# EUROPÄISCHE PATENTSCHRIFT

(11) **EP 3 303 788 B1**
(45) Veröffentlichungstag und Bekanntmachung des Hinweises auf die Patenterteilung: **20.03.2019**
(21) Anmeldenummer: 16727478.6
(22) Anmeldetag: 03.06.2016
(51) Int. Cl.: F01N 5/02, F02G 5/04, F02G 5/02

(54) **THERMOELEKTRISCHER GENERATOR**
THERMOELECTRIC GENERATOR
GÉNÉRATEUR THERMOÉLECTRIQUE

(30) Priorität: 05.06.2015 DE 102015210398
(43) Veröffentlichungstag der Anmeldung: 11.04.2018
(73) Patentinhaber: Bombardier Transportation GmbH, 10785 Berlin (DE)
(72) Erfinder: BARTHELMES, Georg, 79618 Rheinfelden (DE); GERADTS, Karlheinz, 5603 Staufen AG (CH); BUCHER, Samuel, 3012 Bern (CH)
(74) Vertreter: Patentanwälte Bressel und Partner mbB
(86) Internationale Anmeldenummer: PCT/EP2016/062689
(87) Internationale Veröffentlichungsnummer: WO 2016/193453

(56) Entgegenhaltungen:
- EP-A1- 2 180 534
- WO-A1-2011/107282
- DE-A1-102011 005 206
- DE-A1-102011 005 246
- JP-A- H11 122 960

## Beschreibung

Die Erfindung betrifft einen thermoelektrischen Generator zur Umwandlung von Wärme eines heißen Gasstroms in elektrische Energie, ein Schienenfahrzeug mit einem solchen thermoelektrischen Generator und ein Verfahren zum Herstellen eines solchen thermoelektrischen Generators.

Z.B. aus DE 10 2009 058 550 A1 ist die Verwendung eines thermoelektrischen Generators in einer Abgasleitung einer Verbrennungskraftmaschine bekannt. Auf diese Weise kann Wärme des Abgasstroms in elektrische Energie umgewandelt werden. Ein thermoelektrisches Modul des Generators mit mehreren in Reihe geschalteten thermoelektrischen Elementen, die zwischen einer Hochtemperaturseite und einer Niedertemperaturseite angeordnet sind, befindet sich jeweils zwischen einer Modulgehäuseplatte auf der Hochtemperaturseite und der Niedertemperaturseite. Die Modulgehäuseplatten sind Teil eines Modulgehäuses, das die thermoelektrischen Elemente und ein elastisches Ausgleichselement vollständig umschließt. Durch das so geschaffene vollständig gekapselte Modul soll eine Beschädigung und Verschmutzung der thermoelektrischen Elemente verhindert werden.

WO 2011/107282 A1 beschreibt eine Vorrichtung zur Abgaswärmenutzung bei Verbrennungsmotoren von Kraftfahrzeugen. Ein abgasdurchströmtes Gehäuse weist einen Einlass und einen Auslass für einen Abgasstrom auf. Mehrere thermoelektrische Module sind wärmeleitend am Gehäuse angebracht. Die Module erstrecken sich durch Öffnungen eines Rohrabschnitts hindurch und ragen damit sowohl in einen Strömungskanal des Gehäuses als auch in einen Kühlgasstrom außerhalb des Gehäuses. Wärmeleitrippen können zur Verbesserung der thermischen Kopplung der thermoelektrischen Module vorgesehen sein.

Die Erfindung ist nicht auf die Verwendung eines thermoelektrischen Generators in einer Abgasleitung einer Verbrennungskraftmaschine, z. B. eines Dieselmotors eines Schienen-Triebfahrzeugs, beschränkt. Bei dem heißen Gasstrom kann es sich vielmehr auch um einen anderen Gasstrom als einen Abgasstrom handeln, z. B. in einer industriellen Produktions- und/oder Verarbeitungsanlage oder einem thermischen Kraftwerk (zum Beispiel Blockheizkraftwerk). Insbesondere ist es auch möglich, dass der heiße Gasstrom über einen Wärmetauscher an einen Abgasstrom z. B. einer Verbrennungskraftmaschine oder an einen anderen Wärmestrom angekoppelt ist und daher die Wärme aus dem Wärmestrom über den Wärmetauscher in den heißen Gasstrom übertragen wird, der an der Hochtemperaturseite des thermoelektrischen Generators entlangströmt. Bei dieser Variante würde der heiße Gasstrom als Wärmeträgermedium zwischen beispielsweise dem Abgasstrom oder allgemein einer heißen Wärmequelle und der Hochtemperaturseite des thermoelektrischen Generators fungieren.

Problematisch für thermoelektrische Generatoren ist die thermische Ausdehnung und thermische Kontraktion im Verlauf der thermischen Zyklen, die durch Lastwechsel der Verbrennungskraftmaschine oder allgemein der heißen Wärmequelle verursacht werden und jeweils mit der Erwärmung des thermoelektrischen Generators bei Betriebsaufnahme beginnen und mit der Abkühlung des thermoelektrischen Generators am Ende des Betriebes enden. Die in WO 2011/107282 A1 beschriebene Vorrichtung zur Abgaswärmenutzung erlaubt durch Aufnahme der thermoelektrischen Module in Öffnungen der Gehäusewand zwar eine zwängungsfreie thermische Ausdehnung in Richtung des Temperaturgradienten, der von der Außenseite des Gehäuses in das Gehäuseinnere verläuft. Jedoch entstehen thermisch bedingte Zwängungen der thermoelektrischen Module quer zur Richtung des Temperaturgradienten.

Ein weiteres Problem stellt die Effizienz der Umwandlung von Wärme in elektrische Energie dar. Neben der Wahl der Materialien für die thermoelektrischen Elemente ist die wirksame Temperaturdifferenz von Bedeutung. Die Effizienz ist groß, wenn die Temperaturdifferenz zwischen der Hochtemperaturseite und der Niedertemperaturseite des thermoelektrischen Moduls groß ist. Während des Betriebes wird lediglich ein Teil der Wärme auf der Hochtemperaturseite in elektrische Energie umgewandelt. Ein anderer Teil der Wärme erwärmt das thermoelektrische Modul nicht nur an der Hochtemperaturseite, sondern auch, wenn auch in geringerem Maße, auf der Niedertemperaturseite. Aus diesem Grund wird das Gehäuse der Vorrichtung aus WO 2011/107282 A1 an seiner Außenseite gekühlt.

Trotz Kühlung stellt sich z.B. bei stationären Verhältnissen mit konstantem heißem Gasstrom und konstantem Kühlfluidstrom in dem thermoelektrischen Modul eine Temperaturdifferenz ein, die erheblich geringer ist als die Temperaturdifferenz zwischen heißem Gasstrom und Kühlfluidstrom. Die Entfernung zwischen dem Kontakt des Materialpaares auf der Hochtemperaturseite und dem Kontakt des Materialpaares auf der Niedertemperaturseite beträgt in der Praxis oft nur wenige Millimeter.

Zusätzlich zum nützlichen Wärmefluss zu der Hochtemperaturseite des thermoelektrischen Modules, von dem ein Teil in elektrische Leistung umgewandelt werden kann, stellen sich parasitäre Wärmeflüsse zwischen der Hochtemperaturseite und der Niedertemperaturseite ein, die am thermoelektrischen Modul vorbei fließen. Diese parasitären Wärmeflüsse werden einerseits über den Gasraum in der Umgebung der thermoelektrischen Module durch Wärmeleitung, Konvektion und Wärmestrahlung übertragen und andererseits über Festkörper-Wärmebrücken zwischen Hochtemperaturseite und Niedertemperaturseite. Diese Festkörper-Wärmebrücken werden bei anderen thermoelektrischen Generatoren als in WO 2011/107282 A1 beschrieben beispielsweise durch Stützstrukturen gebildet, die die mechanische Belastung der thermoelektrischen Module gering halten sollen.

Noch ein weiteres Problem der Nutzung thermoelektrischer Module mit mehreren, insbesondere in Reihe geschalteten thermoelektrischen Elementen stellt die Empfindlichkeit der thermoelektrischen Module gegen Komponenten des heißen Gasstroms dar. Üblich ist die Verwendung von Halbleitermaterialien für die thermoelektrischen Elemente. Aber auch Träger, insbesondere platinenartige Träger, der thermoelektrischen Elemente können gegen Komponenten des heißen Gasstroms empfindlich sein. Dies ist z.B. der Fall, wenn Oberflächenbereiche des thermoelektrischen Moduls verkupfert sind. Insbesondere Partikel im Abgasstrom, aber auch andere Komponenten wie z.B. Schwefel können die Oberflächen des thermoelektrischen Moduls durch chemische Reaktionen beschädigen.

Es ist eine Aufgabe der vorliegenden Erfindung, einen thermoelektrischen Generator zur Umwandlung von Wärme eines heißen Gasstroms in elektrische Energie anzugeben, der eine Umwandlung der Wärme im heißen Gasstrom in elektrische Energie bei hoher Effizienz ermöglicht, der eine hohe Anzahl von thermischen Zyklen ohne Beschädigung oder Zerstörung thermoelektrischer Module durch mechanische Zwängungen ermöglicht und der thermoelektrische Elemente und/oder Module vor Komponenten des heißen Gasstroms schützt. Eine weitere Aufgabe ist es, ein Schienenfahrzeug mit einem solchen thermoelektrischen Generator und ein Verfahren zum Herstellen eines solchen thermoelektrischen Generators anzugeben.

Die beigefügten Ansprüche definieren den Schutzumfang.

Gemäß einem Grundgedanken der vorliegenden Erfindung wird ein Wärmeübertrager verwendet, der Wärme von dem heißen Gasstrom auf das jeweilige thermoelektrische Modul überträgt. Ein Beispiel für einen solchen Wärmeübertrager ist die in WO 2011/107282 A1 erwähnte Wärmeleitrippe, die sich von dem thermoelektrischen Modul in den heißen Gasstrom hineinerstreckt. Allgemein wird als Wärmeübertrager ein Teil (Wärmleitkörper) aus festem Material bevorzugt, das insbesondere einen möglichst hohen Wärmeleitkoeffizienten hat. Ein Beispiel dafür ist Aluminium.

Zusätzlich wird eine Abdichtung verwendet, die auch als Raumteiler bezeichnet werden kann. Diese Abdichtung trennt den Raum, durch den der heiße Gasstrom strömt, von einem Raum, der sich zwischen dem Raum für den heißen Gasstrom und der Niedertemperaturseite des jeweiligen thermoelektrischen Moduls befindet. Dieser abgetrennte Raum enthält einen Abschnitt des zumindest einen Wärmeübertragers, aber auch Gas und/oder ein wärmeisolierendes Material. Sowohl im Fall von Gas als auch von wärmeisolierendem Material wird verhindert, dass das heiße Gas in dem Gasstrom unmittelbar in Kontakt mit der Niedertemperaturseite des thermoelektrischen Moduls kommt. Die Abdichtung verhindert daher diesen Kontakt. Im Fall eines wärmeisolierenden Materials kann dessen Oberfläche, die dem heißen Gasstrom zugewandt ist, als Abdichtung bezeichnet werden. In dem Fall, dass der von der Abdichtung abgetrennte Raum Gas enthält, insbesondere ausschließlich Gas, und einen Abschnitt des Wärmeübertragers enthält, kann die Abdichtung z.B. plattenförmig oder schichtförmig oder blattförmig sein, d.h. die Abmessung der Abdichtung in der Richtung, in die der Wärmeübertrager die Wärme von dem heißen Gasstrom zu dem thermoelektrischen Modul überträgt, ist kleiner als die Abmessungen der Abdichtung in den Richtungen quer zu der Wärmeübertragungsrichtung des Wärmeübertragers. Die Abdichtung kann in diesem Fall auch als wandartig bezeichnet werden, da sie den Raum für den heißen Gasstrom von dem Raum mit Gas trennt.

Die Abdichtung kann z. B. aus einem geschlossenen oder aus einem porösen Material bestehen. Falls die Abdichtung aus porösem Material besteht oder poröses Material aufweist, dann wird es bevorzugt, dass der Strömungswiderstand einer Gasströmung durch die Abdichtung hindurch deutlich größer ist als der Strömungswiderstand des heißen Gasstromes.

Bevorzugt wird, dass die Abdichtung aus einem flexiblen Material besteht. Dies bedeutet, dass auf sie einwirkende mechanische Kräfte zu einer Verformung der Abdichtung führen. Daher werden über die Abdichtung lediglich geringe und vorzugsweise vernachlässigbar kleine Kräfte auf das thermoelektrische Modul übertragen und das thermoelektrische Modul mitsamt dem Wärmeübertrager kann sich während der oben erwähnten thermischen Zyklen zwängungsfrei ausdehnen und kontrahieren.

Besonders bevorzugt wird als Material der Abdichtung ein Vlies oder Gewebe aus Fasern, wobei das Vlies oder Gewebe optional mit zumindest einem weiteren, vorzugsweise ebenfalls flexiblen Material kombiniert ist, z.B. einer Beschichtung der einzelnen Fasern und/oder des Vlieses oder Gewebes. Wegen ihrer Temperaturbeständigkeit auch bei hohen Gasstromtemperaturen bis zu einigen 100°C oder höher sind zur Herstellung des Vlieses oder Gewebes Mineralfasern, insbesondere künstliche Mineralfasern, gut geeignet.

Insbesondere kann die Abdichtung zumindest an einer Stelle von dem Wärmeleitkörper oder einem der Wärmeleitkörper oder von dem thermoelektrischen Modul durchdrungen sein. Alternativ oder zusätzlich sind Teile der Abdichtung zumindest an einer Stelle durch den Wärmeleitkörper oder einen der Wärmeleitkörper oder durch das thermoelektrische Modul voneinander getrennt, d.h. die verschiedenen Teile der Abdichtung erstrecken sich auf einander gegenüberliegenden Seiten des Wärmeleitkörpers oder thermoelektrischen Moduls, wobei die Verbindung der einander gegenüberliegenden Seiten entlang der Strömungsrichtung des heißen Gasstroms verläuft. Insbesondere ist es auf diese Weise möglich, dass eine Mehrzahl oder Vielzahl von Wärmeleitkörpern oder von Vorsprüngen zumindest eines Wärmeleitkörpers sich durch die Abdichtung hindurch und/oder zwischen verschiedenen Teilen der Abdichtung hindurch erstreckt, und zwar in einer Richtung, die von der Niedertemperaturseite des thermoelektrischen Moduls quer zur Strömungsrichtung des heißen Gasstromes in diesen hinein verläuft bzw. umgekehrt. Daher kann während des Betriebes des thermoelektrischen Generators ein Wärmestrom durch den Wärmeleitkörper zu den thermoelektrischen Elementen stattfinden, während die Abdichtung auf verschiedenen Seiten des Wärmeleitkörpers den Raum für den heißen Gasstrom von dem Raum zwischen Abdichtung und Niedertemperaturseite des thermoelektrischen Moduls trennt.

Der zumindest eine Wärmeleitkörper hat innerhalb des Raumes für den heißen Gasstrom ein freies Ende, das von dem heißen Gasstrom an allen Seiten mit Ausnahme der Seite in Richtung des Verlaufs des Wärmeleitkörpers zu der Niedertemperaturseite des thermoelektrischen Moduls von dem heißen Gas umströmt werden kann und während des Betriebes auch umströmt wird. Insbesondere können daher Vorsprünge, die durch den Wärmeleitkörper oder durch eine Mehrzahl der Wärmeleitkörper gebildet sind, sich in den Gaskanal hinein erstrecken, der den Raum für die Strömung des heißen Gases bildet. Z.B. können die Vorsprünge als Rippen eines Wärmeübertrages zum Übertragen der Wärme des heißen Gasstroms auf das thermoelektrische Modul ausgestaltet sein. Daher besteht z.B. die Möglichkeit, dass ein einteiliger Wärmeleitkörper mehrere Vorsprünge und insbesondere mehrere rippenförmige Vorsprünge bildet. Alternativ oder zusätzlich können verschiedene Wärmeleitkörper jeweils zumindest einen Vorsprung, insbesondere einen rippenförmigen Vorsprung, bilden.

Das freie Ende ist nicht in Kontakt mit anderen Festkörpern. Daher werden durch thermische Ausdehnung und Kontraktion keine mechanischen Kräfte auf das freie Ende und den Wärmleitkörüer ausgeübt und finden daher keine Zwängungen des thermoelektrischen Moduls statt.

Je nach Art des Wärmeleitkörpers, aber auch abhängig von den Materialien des thermoelektrischen Moduls, insbesondere abhängig von der Wärmeleitfähigkeit und einem etwaigen Bedarf für Schutz gegen schädliche Komponenten des heißen Gasstroms, kann die Abdichtung an unterschiedlichen Positionen in Richtung der Wärmeleitung durch den Wärmeleitkörper positioniert sein/werden. Z.B. kann die Abdichtung an einem Abschnitt eines durch den Wärmeleitkörper gebildeten Vorsprungs positioniert sein/werden, sodass der Vorsprung die Abdichtung durchdringt und/oder verschiedene Teile der Abdichtung voneinander trennt. Es ist aber auch möglich, dass die Abdichtung im Bereich des festen Endes des Wärmeleitkörpers positioniert ist, d.h. in dem Bereich, in dem die verschiedenen Materialien der thermoelektrischen Elemente des thermoelektrischen Moduls auf dessen Hochtemperaturseite miteinander in Kontakt sind. Außerdem ist es möglich, dass die Abdichtung an einer Position zwischen dem Kontaktbereich der Materialpaare auf der Hochtemperaturseite und dem Kontaktbereich der Materialpaare des thermoelektrischen Generators auf der Niedertemperaturseite angeordnet ist. In diesem Fall liegt der Kontaktbereich der Materialpaare des thermoelektrischen Moduls in dem Raum, der von dem heißen Gas durchströmt wird. Allgemeiner formuliert wird aber bevorzugt, dass im Fall von thermoelektrischen Elementen, die jeweils ein Paar verschiedener Materialien aufweisen, die in einem ersten Kontaktbereich an der Niedertemperaturseite miteinander in Kontakt sind und in einem zweiten Kontaktbereich an der Hochtemperaturseite miteinander in Kontakt sind, sodass aufgrund einer höheren Temperatur in dem zweiten Kontaktbereich als in dem ersten Kontaktbereich eine elektrische Spannung zwischen dem ersten und dem zweiten Kontaktbereich erzeugt wird, sich der erste Kontaktbereich in dem Raum befindet, den die Abdichtung von dem Gaskanal trennt. Ferner wird bevorzugt, dass der zweite Kontaktbereich sich ebenfalls in dem Raum befindet, den die Abdichtung von dem Gaskanal trennt. Allerdings befindet sich die Abdichtung vorzugsweise nahe an dem zweiten Kontaktbereich. Insbesondere ist die Entfernung des zweiten Kontaktbereichs zu der Abdichtung in Richtung des Verlaufs des Wärmeleitkörpers zu seinem freien Ende im Gaskanal vorzugsweise höchstens ein Zehntel und insbesondere höchstens ein Zwanzigstel der Länge des Wärmeleitkörpers von der Position der Abdichtung bis zum freien Ende im Gaskanal oder, in einem anderen Fall, der Länge des Endbereichs des thermoelektrischen Moduls ausgehend von der Position der Abdichtung zuzüglich der Länge des Wärmeleitkörpers bis zu dessen freien Ende in der genannten Richtung, in der der Wärmetransport stattfindet.

Es wurde bereits erwähnt, dass sich die Abdichtung zwischen verschiedenen Vorsprüngen des Wärmeleitkörpers oder einer Mehrzahl der Wärmeleitkörper erstrecken kann bzw. Teile der Abdichtung sich dazwischen erstrecken können. In diesem Fall, aber auch allgemein gemäß den Ansprüchen erstreckt sich die Abdichtung von den Wärmeleitkörpern oder von einem der Wärmeleitkörper zu einer Gaskanalwand oder zu einem tragenden Teil des thermoelektrischen Generators, z.B. zu einem Gehäuseteil des thermoelektrischen Generators. Unter einem tragenden Teil ist ein Teil des Generators zu verstehen, das irgendeine tragende Funktion hat. Dies kann die Funktion sein, das thermoelektrische Modul zu tragen und/oder ein anderes Teil des thermoelektrischen Generators zu tragen. Insbesondere kann das tragende Teil mit einem Kühlkörper zum Kühlen des thermoelektrischen Moduls verbunden sein. Obwohl sich die Abdichtung zu dem tragenden Teil erstreckt, ist sie aber vorzugsweise nicht fest mit dem tragenden Teil verbunden. Dies verhindert die Zwängung, d.h. die Übertragung von mechanischen Kräften in erheblichem Umfang von dem tragenden Teil auf das thermoelektrische Modul oder umgekehrt.

In Bezug auf die Erfindung wird bevorzugt, ein Kühlmedium zum Abtransport von Wärme aus dem Kühlkörper mit hoher Wärmekapazität zu verwenden, das heißt Flüssigkeiten wie Wasser werden gegenüber Gasen bevorzugt.

Optional kann der Raum, den die Abdichtung von dem Gaskanal trennt, separat von dem Gaskanal einen Einlass und einen Auslass aufweisen, durch die vor, während und/oder nach einem Betrieb des thermoelektrischen Generators ein Spülfluid (vorzugsweise ein Spülgas) zum Spülen des Raums einlassbar und auslassbar ist. Unter einem separaten Einlass und Auslass wird verstanden, dass das Spülfluid in den Raum einlassbar und auslassbar ist, ohne durch den Gaskanal zu strömen. Dies ermöglicht es, den Raum zu reinigen und insbesondere von Resten oder Teilen zu reinigen, die aufgrund einer Undichtigkeit der Abdichtung aus dem Gaskanal in den Raum gelangen oder gelangt sind. Insbesondere wenn der Gaskanal während des Betriebes auch von Rußpartikeln durchströmt wird, ist das Spülen insbesondere während des Betriebes des thermoelektrischen Generators, aber auch davor und/oder danach von Vorteil. Wenn das Spülfluid während des Betriebes durch den abgetrennten Raum strömt, kann es sich z.B. um ein Gas (z.B. Luft) handeln, das unter einem höheren Druck durch den Raum strömt als der Druck des Gases in dem heißen Gasstrom. Dies verhindert, dass ein Teil des heißen Gasstroms in den gespülten Raum gelangt, da der Druck in dem gespülten Raum höher ist.

Gemäß einem weiteren grundlegenden Gedanken der Erfindung weist der thermoelektrische Generator einen Kühlkörper auf, der der Kühlung des thermoelektrischen Moduls dient. Insbesondere wird der Kühlkörper von einem Kühlfluid, vorzugsweise einer Kühlflüssigkeit, durchflossen, sodass eine effektive Kühlung des Kühlkörpers und somit des thermoelektrischen Moduls stattfindet. Der Kühlkörper ist an einer Niedertemperaturseite des thermoelektrischen Moduls mit diesem in Kontakt. Selbstverständlich kann der thermoelektrische Generator eine Mehrzahl von thermoelektrischen Modulen aufweisen, die in Kontakt mit demselben Kühlkörper sind und/oder auf ihrer Niedertemperaturseite in Kontakt mit getrennten, verschiedenen Kühlkörpern sind.

Es wird ein thermoelektrischer Generator gemäss Anspruch 1 vorgeschlagen.

Ferner gehört zum Umfang der Erfindung ein Schienenfahrzeug mit einem thermoelektrischen Generator in einer der Ausgestaltungen des thermoelektrischen Generators, die in dieser Beschreibung, den Ansprüchen und der Zeichnung offenbart sind, wobei das Schienenfahrzeug einen Verbrennungsmotor aufweist und der thermoelektrische Generator in einem Abgasstrang des Motors angeordnet oder mit dem Abgasstrang thermisch gekoppelt ist.

Außerdem wird vorgeschlagen: ein Verfahren zum Herstellen eines thermoelektrischen Generators gemäss Anspruch 11.

In der Praxis wird die Abdichtung den Raum nicht vollständig gegen den Gaskanal abdichten, wie dies in der Regel bei Dichtungen jeglicher Art auch nicht der Fall ist. Zum Beispiel an Kontaktstellen zwischen der Abdichtung und dem Wärmeleitkörper und/oder dem thermoelektrischen Modul kann ein Durchtritt von heißem Gas in den Raum möglich sein. In jedem Fall bewirkt die Abdichtung jedoch eine Trennung zwischen dem Raum und dem Gaskanal, die ein Eintreten von heißem Gas in den Raum behindert oder sogar nahezu vollständig verhindert.

Es wird bevorzugt, dass der Kühlkörper das thermoelektrische Modul trägt. Es kann daher auf Stützstrukturen und damit Festkörper-Wärmebrücken zwischen Hochtemperaturseite und Niedertemperaturseite der thermoelektrischen Module verzichtet werden, so dass die parasitären Wärmeflüsse gering bleiben und die Temperaturdifferenz über die thermoelektrischem Module möglichst nahe an der Temperaturdifferenz zwischen heißem Gasstrom und Kühlfluid liegt.

Insbesondere in Fahrzeugen, z.B. Schienenfahrzeugen, wird der zur Verfügung stehende Raum für Verbrennungsmotoren und im Unterflurbereich bereits gut genutzt. Für den thermoelektrischen Generator steht daher kein oder wenig zusätzlicher Raum zur Verfügung. Dies betrifft auch etwaige zusätzliche Abgaswärmeübertrager, um Abgaswärme auf einen separaten heißen Gasstrom von dem Abgaswärmeübertrager zu dem thermoelektrischen Generator zu übertragen, und/oder eine separate Kühlung zum Kühlen des thermoelektrischen Generators. Entsprechendes gilt für zusätzliches Gewicht, das so gering wie möglich sein soll. Bereits aus diesem Grund werden in Fahrzeugen Systeme ohne zusätzliche Kreisläufe für den heißen Gasstrom bevorzugt.

Insbesondere für die Verwendung in Fahrzeugen, aber auch generell wird daher bevorzugt, den Bauraum für den thermoelektrischen Generator gut auszunutzen, indem mehrere Wärmeleitkörper vorgesehen werden bzw. verwendet werden, die sich von verschiedenen Seiten des Gaskanals für den heißen Gasstrom in den Gaskanal hinein erstrecken und dort ein freies Ende haben. Z.B. kann sich eine erste Gruppe von mehreren Wärmeleitkörpern oder Vorsprüngen in der Art eines Kamms von einer Seite des Gaskanals in diesen hinein erstrecken und kann eine zweite Gruppe von Wärmeleitkörpern oder Vorsprüngen sich in der Art eines zweiten Kamms von einer anderen Seite in den Gaskanal hinein erstrecken, sodass einzelne Vorsprünge des ersten Kamms sich in Zwischenräumen von Vorsprüngen des zweiten Kamms erstrecken und umgekehrt. Die Vorsprünge der verschiedenen Kämme sind ineinander verschränkt.

Insbesondere können sich die beiden Kämme voneinander gegenüberliegenden Seiten in den Gaskanal hinein erstrecken, sodass sich freie Enden von Vorsprüngen des ersten Kamms zwischen Vorsprüngen des zweiten Kamms befinden und umgekehrt. Insbesondere bilden die Vorsprünge des ersten Kamms und des zweiten Kamms dabei Wände von Strömungskanälen für den heißen Gasstrom, d.h. diese Strömungskanäle bilden gemeinsam und optional mit zusätzlichen Strömungskanälen den Gesamtquerschnitt, der für die Durchströmung mit dem heißen Gas zur Verfügung steht. Quer zur Strömungsrichtung entlang der gegenüberliegenden Seiten, von denen aus sich die Vorsprünge der beiden Kämme in den Gaskanal hinein erstrecken, können die Vorsprünge des ersten Kamms und die Vorsprünge des zweiten Kamms alternierend aufeinander folgen. In all diesen Fällen wird jedoch bevorzugt, dass die Vorsprünge des ersten Kamms und die Vorsprünge des zweiten Kamms einander nicht berühren.

Nicht nur im Fall der zuvor beschriebenen kammartigen Gruppen von Vorsprüngen, sondern allgemein im Fall mehrerer Vorsprünge, die sich in das Innere des Gaskanals hinein erstrecken und Wärme zumindest einem thermoelektrischen Modul zuführen, wird bevorzugt, dass die Mehrzahl der Vorsprünge insbesondere wie bereits beschrieben oder auf andere Weise Strömungskanäle bilden, die gemeinsam zum GesamtStrömungsquerschnitt des Gaskanals beitragen. Die einzelnen Strömungskanäle weisen daher einen kleineren Strömungsquerschnitt als der gesamte Gaskanal auf. Dies führt zu einer schalldämpfenden Eigenschaft, sodass der thermoelektrische Generator insbesondere als Abgasschalldämpfer im Abgasstrom eines Verbrennungsmotors eingesetzt werden kann. Dies wiederum ermöglicht es, einen vorhandenen oder bei Anlagen gleichen Typs sonst vorhandenen Abgasschalldämpfer durch den thermoelektrischen Generator zu ersetzen. Es wird daher kein oder nur wenig zusätzlicher Bauraum benötigt. Entsprechendes gilt für das zusätzliche Gewicht.

Unabhängig von der Möglichkeit, die mehreren Teil-Strömungskanäle auszubilden, wird bevorzugt, dass der thermoelektrische Generator eine beliebige Kombination der folgenden Merkmale aufweist:
- Eine Mehrzahl thermoelektrischer Module (z.B. streifenförmige Module oder blockförmige Module), die jeweils eine Mehrzahl von thermoelektrischen Elementen aufweisen, werden über Wärmeleitkörper an den Gaskanal thermisch angekoppelt, vorzugsweise an einen Abgaskanal ohne Zwischenkreislauf.
- Der thermoelektrische Generator ist modular aus Grundeinheiten aufgebaut.
- Jede der Grundeinheiten kann einen Kühlkörper, zumindest ein thermoelektrisches Modul, das an seiner Niedertemperaturseite an den Kühlkörper angekoppelt ist, zumindest einen Wärmeleitkörper mit Vorsprüngen, die in ihrem Verlauf bis zu ihren freien Enden in den Gaskanal hineinragen, die erfindungsgemäße Abdichtung und optional zumindest eine Verbindung zwischen dem Kühlkörper und dem jeweiligen thermoelektrischen Modul aufweisen. Diese Verbindung dient einer guten thermischen Ankopplung des thermoelektrischen Moduls an den Kühlkörper. Beispiele werden noch näher beschrieben. Durch diesen modularen Aufbau können thermoelektrische Generatoren mit unterschiedlicher Anzahl von Grundeinheiten entsprechend unterschiedlichen zu erwartenden Wärmeströmen hergestellt werden.
- Mehrere Grundeinheiten können in einer Richtung quer zur Strömungsrichtung des heißen Gases nebeneinander angeordnet sein. Insbesondere wie bereits beschrieben können Grundeinheiten vorzugsweise auf einander gegenüberliegenden Seiten des Gaskanals angeordnet sein/werden, d.h. es befindet sich an den gegenüberliegenden Seiten des Gaskanals zumindest ein thermoelektrisches Modul, von dem aus sich Wärmeleitkörper oder Vorsprünge in das Innere des Gaskanals hinein erstrecken. Insbesondere am Ende einer aus mehreren Grundeinheiten bestehenden Baugruppe kann sich auch lediglich eine Grundeinheit befinden, d.h. es ragen in einen Gaskanal lediglich von einer Seite Wärmeleitkörper und/oder Vorsprünge in das Innere des Gaskanals hinein oder durchdringen den Gaskanal bis annähernd zur gegenüberliegenden Seite. Ein Beispiel wird noch beschrieben.
- Insbesondere bildet der Kühlkörper der Grundeinheit das tragende Teil, welches das zumindest eine an ihn angekoppelte thermoelektrische Modul trägt. Der Kühlkörper wird daher an ein tragendes Teil des thermoelektrischen Generators mechanisch angekoppelt, d.h. verbunden. Das thermoelektrische Modul wird lediglich indirekt über den Kühlkörper mit dem tragenden Teil des thermoelektrischen Generators verbunden. Dies ermöglicht es, die thermoelektrischen Module zwängungsfrei anzuordnen. Das tragende Teil des thermoelektrischen Generators ist in einem Ausführungsbeispiel ein Tragrahmen, z.B. ein unten liegender Tragrahmen. Es kann ein weiterer, z.B. oben liegender Tragrahmen vorgesehen sein, der jedoch nicht die Kühlkörper trägt, aber Teil eines Gehäuses des thermoelektrischen Generators ist.
- Wenn die bereits erwähnte Verbindung zwischen dem Kühlkörper und dem zumindest einen thermoelektrischen Modul vorhanden ist bzw. vorgesehen wird, kann die Verbindung aus zumindest einem z.B. rippenförmigen Wärmeleitkörper bestehen oder diese aufweisen, wobei dieser Wärmeleitkörper sich von dem Kühlkörper zu dem thermoelektrischen Modul erstreckt und auf dessen Niedertemperaturseite angeordnet ist. Eine solche Verbindung kann z.B. integraler Teil des Kühlkörpers sein, d.h. es ist kein weiterer mechanischer Übergang von dem Kühlkörper auf die Verbindung erforderlich. Alternativ kann jedoch die Verbindung als separates Verbindungselement ausgestaltet sein. Insbesondere im Fall von streifenförmigen thermoelektrischen Modulen kann jeweils eine Verbindung zwischen dem Modul und dem Kühlkörper vorhanden sein. Dabei kann insbesondere zumindest eine der Verbindungen den Kühlkörper nicht nur mit einem thermoelektrischen Modul, sondern mit einer Mehrzahl thermoelektrischer Module, z.B. mit zwei thermoelektrischen Modulen verbinden.
- Der Wärmeleitkörper oder die Wärmeleitkörper, der/die das jeweilige thermoelektrische Modul während des Betriebes mit Wärme aus dem heißen Gasstrom versorgen, können ein integraler Teil des thermoelektrischen Moduls sein, mechanisch und somit auch thermisch an das jeweilige thermoelektrische Modul angekoppelt sein oder es kann eine zusätzliche Verbindung vorhanden sein, z.B. ein zusätzliches Verbindungselement, das das thermoelektrische Modul mit dem Wärmeleitkörper mechanisch und somit thermisch verbindet. Im Fall der streifenförmigen thermoelektrischen Module kann ähnlich wie für die Niedertemperaturseite beschrieben eine Verbindung oder direkt der Wärmeleitkörper auf der Hochtemperaturseite mit einer Mehrzahl der thermoelektrischen Module verbunden sein, z.B. mit zwei thermoelektrischen Modulen an einander gegenüberliegenden Seiten der Verbindung oder des Wärmeleitkörpers.
- Insbesondere wie oben bereits beschrieben, können an gegenüberliegenden Seiten eines Gaskanals jeweils kammartige Gruppen von Vorsprüngen angeordnet sein, wobei die Vorsprünge der verschiedenen kammartigen Gruppen sich in das Innere desselben Gaskanals hinein erstrecken. Im Fall der Grundeinheiten befindet sich somit an den gegenüberliegenden Seiten des Gaskanals jeweils eine Grundeinheit mit jeweils zumindest einem thermoelektrischen Modul. Der Gaskanal wird an jeder der Seiten durch eine vorzugsweise flexible Abdichtung gegen jeweils einen Raum abgegrenzt, der sich zwischen dem Gaskanal und der Niedertemperaturseite des jeweiligen thermoelektrischen Moduls befindet. Wenn sich die Vorsprünge der einander gegenüberliegenden Grundeinheiten nicht berühren, ist eine zwängungsfreie thermische Ausdehnung und Kontraktion möglich. Z.B. können die Vorsprünge rippenförmig ausgebildet sein und in der bereits erwähnten Weise ineinander verschränkt ausgeführt werden/sein. Auf diese Weise wird Bauraum gespart und die Oberfläche der Wärmeleitkörper insgesamt pro Volumen vergrößert, sodass der Wärmeübergang von dem heißen Gasstrom auf die thermoelektrischen Module insgesamt verbessert ist.
- Optional kann sich bei Verwendung der Grundeinheiten, aber auch allgemein bei einer Vielzahl von sich in den Gaskanal hinein erstreckenden Vorsprüngen die Länge der Vorsprünge, über die sich die Vorsprünge in den Gaskanal bis zu ihrem freien Ende erstrecken, variieren. Insbesondere kann in Strömungsrichtung des heißen Gases diese Länge zunehmen, um die Oberfläche der Wärmeleitkörper in Strömungsrichtung des heißen Gases zu vergrößern. Dadurch wird die Abnahme der Temperatur des heißen Gases in Strömungsrichtung zumindest teilweise kompensiert und wird an verschiedenen Positionen in Strömungsrichtung jeweils ungefähr ein Wärmestrom durch die Wärmeleitkörper in gleicher Größe erzeugt. Insbesondere kann eine erste Grundeinheit Wärmeleitkörper einer ersten, innerhalb der Grundeinheit konstanten Länge aufweisen und eine zweite Grundeinheit Wärmeleitkörper einer zweiten, innerhalb der Grundeinheit konstanten Länge aufweisen. Die erste Grundeinheit wird in Strömungsrichtung vor der zweiten Grundeinheit angeordnet. Es ist jedoch alternativ möglich, die Länge der Wärmeleitkörper innerhalb einer Grundeinheit zu variieren, sodass sie in Strömungsrichtung zunimmt.
- Nicht nur in Bezug auf die Grundeinheiten kann das Material der Abdichtung z.B. schlitzförmige Aussparungen oder schlitzförmige Durchgangsöffnungen für die Wärmeleitkörper aufweisen. Schnitte zum Erzeugen solcher Aussparungen oder Öffnungen können z.B. mit mechanischen Werkzeugen und/oder mittels Wasserstrahlschneiden erzeugt werden.
- Nicht nur bei den Grundeinheiten kann die Abdichtung aus einem kompressiblen Material hergestellt sein.
- Alternativ zu Aussparungen oder Durchgangsöffnungen in dem Material der Abdichtung können nicht nur im Fall der Grundeinheiten, sondern allgemein Teile der Abdichtung flexible streifenförmige Teile sein, z.B. gebogene Folien (beispielsweise aus Metall, Keramik oder temperaturbeständigen Polymeren), aus Fasern hergestellte Faserbündel (beispielsweise Seile) und/oder Hohlkörper aus Kautschuk und/oder Polymer sein. In all diesen Fällen ist darauf zu achten, dass das verwendete Ausgangsmaterial temperaturbeständig ist, d.h. die Temperatur des heißen Gasstroms dauerhaft übersteht.
- Nicht nur in Bezug auf die oben erwähnte Möglichkeit der Spülung des Raums, der von der Abdichtung gegen den Gaskanal abgetrennt ist, kann das Spülen alternativ oder zusätzlich zu dem Zweck der Reinigung für eine Kühlung des Raums genutzt werden. In diesem Fall wird eine zusätzliche Kühlung des durch die Abdichtung getrennten Raumes mittels des Spülfluids (vorzugsweise des Spülgases), insbesondere mit Spülluft, erreicht, die zusätzlich zu der Kühlung des Kühlkörpers stattfindet. Die Temperaturdifferenz der Kontaktbereiche der Materialpaare des thermoelektrischen Moduls zwischen Hochtemperaturseite und Niedertemperaturseite kann daher während des Betriebes des thermoelektrischen Generators größer sein. Insbesondere verläuft die Abdichtung in diesem Fall an einer Position zwischen den Kontaktbereichen der Materialpaare auf der Hochtemperaturseite und den Kontaktbereichen der Materialpaare auf der Niedertemperaturseite. Durch das Spülfluid wird daher im Wesentlichen lediglich der Kontaktbereich auf der Niedertemperaturseite gekühlt.
- Die Grundeinheiten können nicht nur im Fall der sich ändernden Länge der Wärmeleitkörper in Strömungsrichtung des heißen Gases hintereinander angeordnet sein/werden. Optional kann in zumindest einem Übergangsbereich, in dem zwei in Strömungsrichtung hintereinander angeordnete Grundeinheiten einander benachbart sind, zumindest eine Stützstruktur vorgesehen sein, die sich insbesondere außerhalb des Strömungskanals oder der Strömungskanäle für das heiße Gas befindet. Insbesondere kann die Stützstruktur geschlossen um den Gesamtströmungsquerschnitt für den heißen Gasstrom herum verlaufen. Dies ermöglicht es insbesondere, dass die Grundeinheiten an der Stützstruktur und/oder gegeneinander abgestützt oder befestigt werden und daher mechanisch stabilisiert werden. Außerdem kann die Stützstruktur optional Abdichtungen zwischen dem Gaskanal und dem abgetrennten Raum stützen.
- Die Grundeinheiten und insbesondere die in Strömungsrichtung hintereinander angeordneten verschiedenen Grundeinheiten sind in Strömungsrichtung vorzugsweise lediglich an einer Seite (z.B. lediglich in Strömungsrichtung am Anfang des thermoelektrischen Generators oder am Ende des thermoelektrischen Generators) mit einer Tragstruktur des Generators verbunden, bei der es sich z.B. um einen Tragrahmen handeln kann. Dies ermöglicht die zwängungsfreie thermische Ausdehnung und Kontraktion. Optional kann sich in Strömungsrichtung in einem Abstand zu der Befestigung der Grundeinheiten an der Tragstruktur eine Führung befinden oder in Strömungsrichtung erstrecken, wobei die Führung eine thermische Ausdehnung und Kontraktion der Anordnung der Grundeinheiten ermöglicht. Es ist daher eine Relativbewegung zumindest einer Grundeinheit und der Führung möglich, d.h. die Führung ist mit keiner der von der Tragstruktur getragenen Grundeinheiten fest verbunden. Die Führung befindet sich insbesondere seitlich, d.h. außerhalb des Randes des Gaskanals oder der Gaskanäle. Es kann auch eine Mehrzahl solcher Führungen vorgesehen sein.
- Insbesondere bei Verwendung von streifenförmigen thermoelektrischen Modulen können die thermoelektrischen Module in einer Richtung quer zur Strömungsrichtung des heißen Gases nebeneinander angeordnet sein. Sie bilden dabei einen Stapel streifenförmiger Module, wobei die streifenförmigen Module jeweils paarweise voneinander beabstandet sind. In diesem Fall können zusätzliche plattenförmige Abschlusselemente vorgesehen sein, z.B. Abschlussbleche, die zumindest auf einer Seite des Stapels das in der Reihenfolge der streifenförmigen Module letzte Element des Stapels bilden. Die Abschlusselemente begrenzen daher den Raum, der teilweise für die Durchströmung mit heißem Gas zur Verfügung steht, seitlich und bilden somit den Rand dieses Raums. Mehrere solcher plattenförmiger Abschlusselemente können gegeneinander verschieblich ausgestaltet sein, um mechanische Zwängungen infolge thermischer Ausdehnung und Kontraktion zu vermeiden oder gering zu halten. Die Abschlusselemente können insbesondere von der bereits genannten Tragstruktur getragen oder zumindest zeitweise, abhängig vom Zustand der thermischen Ausdehnung oder Kontraktion gestützt werden. Optional kann eine zweite Tragstruktur vorgesehen sein, die relativ zu der ersten Tragstruktur in Strömungsrichtung beabstandet ist und relativ zu der ersten Tragstruktur in Strömungsrichtung beweglich gelagert ist und insbesondere beweglich geführt ist. Auch dies vermeidet thermische Zwängungen.
- Alternativ oder zusätzlich zur Führung in Strömungsrichtung können die Kühlkörper der Grundeinheiten jeweils zwischen zwei in Strömungsrichtung aufeinander folgenden Etagen von Kühlkörpern senkrecht zur Strömungsrichtung durch plattenförmige Stützstrukturen untereinander verbunden werden, um eine Stabilisierung des thermoelektrischen Generators quer zur Strömungsrichtung zu bewirken. Diese Stützstrukturen haben vorzugsweise Aussparungen für die Strömungskanäle des heißen Gases und, falls vorhanden, des Spülgases. Zusätzlich können diese Stützstrukturen dazu genutzt werden, die Abdichtung zwischen dem heißen Gaskanal und dem nicht vom heißen Gas durchströmten Raum in oder entgegen der Strömungsrichtung abzustützen.

Die hydraulische Verschaltung mehrerer Kühlkanäle des Kühlkörpers oder der Kühlkörper ist dem Fachmann geläufig und wird hier nicht näher beschrieben. Gleiches gilt für die elektrische Verschaltung mehrerer thermoelektrischer Module oder Grundeinheiten. Die elektrischen Anschlüsse zu den thermoelektrischen Modulen können insbesondere in dem Raum liegen, der durch die Abdichtung von dem Gaskanal getrennt ist. Auf diese Weise werden die elektrischen Anschlüsse vor besonders hohen Temperaturen auf dem Temperaturniveau des heißen Gasstromes geschützt.

Anstelle der oben als Beispiel bereits erwähnten streifenförmigen thermoelektrischen Module können blockförmige, insbesondere quaderförmige, thermoelektrische Module verwendet werden. Insbesondere können diese blockförmigen Module an der Niedertemperaturseite eine ebene Oberfläche aufweisen, die eine großflächige thermische Ankopplung an den zugeordneten Kühlkörper ermöglichen. Alternativ oder zusätzlich kann zumindest ein blockförmiges thermoelektrisches Modul an der Hochtemperaturseite eine ebene Oberfläche aufweisen, die eine großflächige Ankopplung eines oder mehrerer Kühlkörper ermöglicht, wobei jeder Kühlkörper eine Mehrzahl von Vorsprüngen aufweisen kann, die sich in den Gaskanal hinein erstrecken. In diesem Fall befindet sich die Abdichtung an einer Position aus Sicht der Niedertemperaturseite des Moduls jenseits der Hochtemperaturseite des Moduls, d.h. im Bereich der Vorsprünge des Kühlkörpers oder der Kühlkörper.

Insbesondere können mehrere der blockförmigen Module thermisch an einem gemeinsamen Kühlkörper angekoppelt werden, z.B. in einem rechteckigen Raster angeordnet werden.

Alternativ oder zusätzlich zu der Anordnung einer Abdichtung zwischen den einzelnen Vorsprüngen des Wärmeleitkörpers kann eine Abdichtung zwischen verschiedenen Anordnungen aus zumindest einem blockförmigen thermoelektrischen Modul und einem daran thermisch angekoppelten Wärmeleitkörper angeordnet sein/werden. Auch in diesem Fall trennt die Abdichtung den Gaskanal von einem Raum zwischen Gaskanal und Niedertemperaturseite der verschiedenen blockförmigen thermoelektrischen Module.

Alternativ zu Wärmeleitkörpern mit mehreren Vorsprüngen, die z.B. durch Extrusion oder Fräsen hergestellt werden können, lassen sich auch die bereits erwähnten, z.B. rippenförmigen, einzelnen Wärmeleitkörper verwenden. In all diesen Fällen können Vorsprünge, z.B. Rippen, die sich voneinander gegenüberliegenden Seiten des Gaskanals in diesen kammartig hineinerstrecken, miteinander verschränkt sein, d.h. die Vorsprünge von der einen Seite wechseln sich mit Vorsprüngen von der anderen Seite ab.

Einzelne Rippen können im Fall blockförmiger thermoelektrischer Module einen L- oder T-förmigen Querschnitt aufweisen, sodass insbesondere ein kurzer Schenkel des L oder T an der Hochtemperaturseite mit dem blockförmigen thermoelektrischen Modul verbunden wird.

Generell, für sämtliche bereits genannten Verbindungen von Teilen und auch für die noch im Folgenden erwähnten Verbindungen können unterschiedliche Fügetechniken angewendet werden, insbesondere Verkleben, Verschweißen, Verlöten, kraftschlüssiges Fügen und/oder formschlüssiges Fügen.

Bei blockförmigen thermoelektrischen Modulen kann es zu thermisch bedingten Wölbungen an den Oberflächen kommen, sodass insbesondere der großflächige Kontakt zu dem Kühlkörper und/oder zu dem Wärmeleitkörper verschlechtert wird. Zur Lösung dieses Problems wird vorgeschlagen, flächige Kompensationselemente, z.B. elastische Kompensationselemente, zwischen dem Kühlkörper und dem Modul und/oder zwischen dem Modul und dem Wärmeleitkörper anzuordnen.

Je nach Ausführung der Abdichtung dämpft diese mehr oder weniger stark mechanische Schwingungen, die insbesondere im Fall eines Abgasstroms im Abgasstrang eines Verbrennungsmotors angeregt werden können. Schwingungsfähig sind insbesondere rippenförmige Wärmeleitkörper. Obwohl die Abdichtung oder die Teile der Abdichtung vorzugsweise flexibel sind, können dennoch die zur Verformung der Abdichtung erforderlichen Kräfte mechanische Schwingungen dämpfen. Insbesondere können die Steifigkeit und/oder Festigkeit der Abdichtung auf die zu erwartenden Frequenzen mechanischer Schwingungen abgestimmt werden, um Schwingungen bei diesen Frequenzen besonders gut zu dämpfen. Entsprechendes gilt für mechanische Schwingungen, die auf andere Weise als durch einen Abgasstrom angeregt werden können. Z.B. können Schwingungen eines Verbrennungsmotors über mechanische Kontakte auf dem thermoelektrischen Generator übertragen werden.

Der zumindest eine Kühlkörper kann insbesondere aus einem Metall, vorzugsweise einem Metall mit hoher Wärmeleitfähigkeit, gefertigt werden, z.B. Aluminium, eine Aluminiumlegierung, eine Kupferlegierung oder Kohlenstoffstahl.

Der Kühlkörper kann aus einem Materialblock gefertigt werden, z.B. durch Fräsen und Bohren. Auf diese Weise können die Kanäle für das Kühlfluid und die Anschlüsse erzeugt werden. Alternativ kann der Kühlkörper als extrudiertes Hohlprofil gefertigt werden. Eine weitere Variante ist die Herstellung in einem Gießverfahren. Auch ist es möglich, den Kühlkörper aus einzelnen Teilen, z.B. Profilen, Rohren und Platten, zu fertigen, z.B. zu schweißen. Als weiteres mögliches Herstellverfahren für den Kühlkörper ist die additive Fertigung (im allgemeinen Sprachgebrauch als "3D-Druck" bekannt) zu nennen. Insbesondere bei gefrästen, gegossenen, geschweißten oder additiv gefertigten Kühlkörpern kann die zur Niedertemperaturseite des thermoelektrischen Moduls weisende Oberfläche als ebene Fläche ausgeführt werden. Insbesondere über zumindest ein zusätzliches Verbindungselement kann die mechanische und thermische Verbindung zwischen Kühlkörper und Modul hergestellt werden. Alternativ kann der Kühlkörper auf der zu dem zumindest einen thermoelektrischen Modul weisenden Seite mit Vorsprüngen gefertigt werden, z.B. rippenförmigen Vorsprüngen, an denen einzelne thermoelektrische Module, insbesondere streifenförmige Module, befestigt werden. Blockförmige und insbesondere quaderförmige Module können direkt auf einer ebenen Oberfläche des Kühlkörpers befestigt werden, optional mit Kompensationselementen zur Kompensation thermischer Verformung der ebenen Oberfläche. Insbesondere bei einem Kühlkörper aus extrudierten Hohlprofilen sowie bei gegossenen, geschweißten oder additiv gefertigten Kühlkörpern kann die Oberfläche für die Verbindung mit dem zumindest einen Modul nachbearbeitet werden (Material z.B. spanend abgetragen werden), bevor das zumindest eine blockförmige Modul an der Oberfläche befestigt wird. Vorzugsweise können Oberflächen des Materials des Kühlkörpers, einschließlich innen liegender Oberflächen am Rand von Kühlflüssigkeitskanälen, beschichtet werden, um das Material resistent gegen Luftsauerstoff, das Kühlmedium und/oder im heißen Gas vorhandene Komponenten auszugestalten.

Verbindungselemente zur mechanischen und thermischen Verbindung von Kühlkörper und thermoelektrischen Modulen können insbesondere aus denselben wie oben für den Kühlkörper genannten Materialien gefertigt werden. Vorzugsweise bestehen das Verbindungselement und der Kühlkörper aus demselben Material. Verbindungselemente können aus Blechen gestanzt, gesägt oder geschnitten werden und optional in eine gewünschte Form (z.B. mit L- oder T-Profil) gebogen oder abgekantet werden. Verbindungselemente können an den Kühlkörper z.B. durch Löten, Kleben oder Schweißen gefügt werden. Mechanische Verbindungen zwischen Verbindungselementen und thermoelektrischen Modulen (insbesondere Modulstreifen) können insbesondere durch Löten oder Kleben hergestellt werden.

Wie erwähnt können thermoelektrische Module z.B. streifenförmig oder blockförmig, insbesondere quaderförmig, sein. Derartige Module sind auf dem Markt erhältlich. Details ihres Aufbaus und ihrer Materialien werden daher in dieser Beschreibung nicht näher beschrieben. Insbesondere um ein Verlöten zu ermöglichen, kann das Modul an der Niedertemperaturseite und/oder an der Hochtemperaturseite aus einem Metall gefertigt sein. Dies schließt die Möglichkeit mit ein, dass die Oberfläche in dem Verbindungsbereich zu dem Verbindungselement oder Wärmeleitkörper metallisiert ist/wird. Dies gilt sowohl für streifenförmige als auch für blockförmige Module. Vorzugsweise ist im Kontaktbereich zwischen Wärmeleitkörper und Modul und/oder zwischen Modul und Kühlkörper und Verbindungselement zum Kühlkörper (oder alternativ zwischen Verbindungselement und Kühlkörper) elektrisch isoliert.

Für den Wärmeleitkörper, der während des Betriebes Wärme von dem heißen Gasstrom zu dem thermoelektrischen Modul überträgt, werden dieselben Materialien wie oben zum Kühlkörper erwähnt, bevorzugt. Im Fall eines thermoelektrischen Modulstreifens können die Wärmeleitkörper z.B. als Streifen von plattenförmigem Material (z.B. Blechstreifen) oder wellenförmige Blechstreifen gefertigt werden. Dabei erstrecken sich die Wellentäler im Gaskanal vorzugsweise in Strömungsrichtung, um zwar eine vergrösserte Oberfläche zu erhalten aber den Strömungswiderstand im Gaskanal nicht wesentlich zu erhöhen. Die wellenförmigen Blechstreifen können dabei ebenso wie die geraden Blechstreifen gegenüberliegend und ineinander verschränkt im Gaskanal angeordnet werden. Mehrere Rippen oder andere Vorsprünge, die in den Gaskanal hineinragen, können z.B. mit Hilfe von Schablonen, Matrizen oder sonstigen Abstandswerkzeugen so ausgerichtet werden, dass sich ein gleichmäßiger Abstand zwischen ihnen ergibt. Vorzugsweise soll der einzelne Abstand nicht mehr als 20 % vom mittleren Abstand zweier Vorsprünge abweichen. Die streifenförmigen oder rippenförmigen Wärmeleitkörper können wie an sich bereits bekannt aus größeren Tafeln oder aus bandförmigem Material gestanzt, geschnitten oder gesägt werden.

Im Fall von blockförmigen thermoelektrischen Modulen werden die Wärmeleitkörper z.B. durch Fräsen oder Extrudieren als Rippen-Körper hergestellt. Wie erwähnt können alternativ im Querschnitt L- oder T-förmige Wärmeleitkörper hergestellt werden, deren kurzer Profilschenkel möglichst vollflächig mit der Oberfläche des blockförmigen Moduls verbunden wird. Alternativ können Stift-Kühlkörper als Wärmeleitkörper verwendet werden, d.h. eine Mehrzahl von stiftförmigen Vorsprüngen erstreckt sich in das Innere des Gaskanals hinein. Insbesondere kann der Wärmeleitkörper durch Löten oder Kleben mit dem Modul verbunden werden. Eine weitere Möglichkeit besteht darin, das Modul bereits mit Vorsprüngen in z.B. Rippenform oder Stiftform an der Hochtemperaturseite herzustellen. In diesem Fall entfällt die Verbindung des Moduls mit einem zusätzlichen Wärmeleitkörper.

Eine flexible Abdichtung, d.h. eine bei Einwirkung von äußeren Kräften sich verformende Abdichtung, kann insbesondere aus bereits vor der Herstellung flexiblem Material oder durch die Herstellung flexibel werdendes Material bestehen. Z.B. können bei der Herstellung der Abdichtung Hohlräume erzeugt werden, die das Material insgesamt flexibel werden lassen. Bevorzugt wird jedoch ein Vlies oder eine Matte aus Mineralfasern als Abdichtung. Z.B. kann in das Vlies oder die Matte ein schlitzförmiges Loch geschnitten oder gestanzt werden. Die Form des Lochs hängt von der Querschnittsform des Wärmeleitkörpers ab, der die Abdichtung an dem Loch durchdringt oder durchdringen soll. Die Abdichtungsfunktion zwischen der Abdichtung und dem Wärmeleitkörper wird bevorzugt durch die Reibung der beiden Teile gewährleistet. Ohne diese Reibung könnte die Abdichtung sich relativ zu dem Wärmeleitkörper bewegen und die Abdichtungsfunktion verschlechtert werden. Eine weitere Möglichkeit besteht darin, dass freie Enden von Wärmeleitkörpern, die sich von einer gegenüberliegenden Seite des Gaskanals aus in den Gaskanal hinein erstrecken, die Abdichtung in Position halten, d.h. die Abdichtung kann sich nicht weiter in Richtung der gegenüberliegenden Seite des Gaskanals bewegen. Alternativ oder zusätzlich kann die Abdichtung z.B. durch eine Halterung an einem Rand-Abschlusselement des Gaskanals und/oder an einer Verstärkungsstruktur gehalten werden und zumindest die Bewegungsfreiheit der Abdichtung auf diese Weise eingeschränkt werden. Alternativ oder zusätzlich kann die Abdichtung an dem Wärmeleitkörper festgeklebt werden. Eine Abdichtung kann nicht nur den erwähnten Raum von dem Gaskanal abtrennen. Vielmehr kann zumindest eine Abdichtung auch dazu verwendet werden, den Übergang zwischen in Strömungsrichtung hintereinander angeordneten Modulen, insbesondere den Grundeinheiten, abzudichten. Hierfür kommen dieselben Materialien wie für die abtrennende Abdichtung infrage. Auch diese Abdichtungen können festgeklebt werden oder durch Klemmkräfte in Position gehalten werden.

Ausführungsbeispiele der Erfindung werden nun unter Bezugnahme auf die beigefügte Zeichnung beschrieben. Die einzelnen Figuren der Zeichnung zeigen:
- Fig. 1: einen Längsschnitt durch eine Anordnung mit zwei Kühlkörpern an gegenüberliegenden Seiten eines Gaskanals, wobei sich ausgehend von jedem der Kühlkörper Richtung Innenraum des Gaskanals thermoelektrische Module mit daran befestigten Wärmeleitkörpern erstrecken,
- Fig. 2: einen Querschnitt durch die in Fig. 1 dargestellte Anordnung entlang der Linie II-II,
- Fig. 3: eine isometrische dreidimensionale Darstellung einer Anordnung mit einem Kühlkörper, von dem aus sich auf einander gegenüberliegenden Seiten thermoelektrische Module mit daran befestigten Wärmeleitkörpern erstrecken,
- Fig. 4: eine isometrische dreidimensionale Darstellung einer Mehrzahl der in Fig. 3 dargestellten Anordnungen, die nebeneinander und in Etagen übereinander angeordnet sind,
- Fig. 5: eine Darstellung von drei Anordnungen ähnlich der in Fig. 3 dargestellten Anordnung, wobei die drei Anordnungen in Strömungsrichtung des heißen Gases hintereinander angeordnet sind und unterschiedliche Längen quer zur Richtung des Gasstromes aufweisen, über die sich die Wärmeleitkörper in den Gaskanal hinein erstrecken,
- Fig. 6: die in Fig. 4 dargestellte Anordnung mit zusätzlichem Tragrahmen, einem Gas-Einlass und einem Gas-Auslass,
- Fig. 7: einen Querschnitt durch einen Kühlkörper, der z.B. als Kühlkörper in einer der Anordnungen in Fig. 1 bis Fig. 6 sowie Fig. 8 und Fig. 9 verwendbar ist,
- Fig. 8: einen Längsschnitt ähnlich dem Längsschnitt in Fig. 1, jedoch durch eine Anordnung mit quaderförmigen thermoelektrischen Modulen statt mit streifenförmigen thermoelektrischen Modulen,
- Fig. 9: einen Querschnitt durch die in Fig. 8 dargestellte Anordnung entlang der Linie IX-IX,
- Fig. 10: einen Ausschnitt entsprechend dem zentralen Bereich der in Fig. 2 dargestellten Anordnung zur Darstellung einer konkreten, von Fig. 2 abweichenden Ausführungsform der Wärmeleitkörper mit Wellenform und
- Fig. 11: ein konkretes Ausführungsbeispiel für eine der in Fig. 4 dargestellten Stützstrukturen.

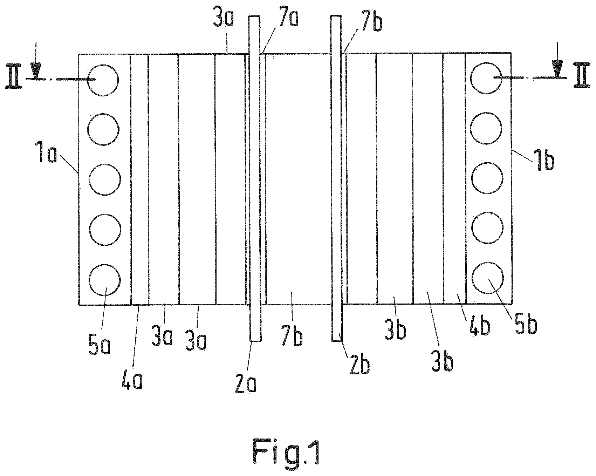

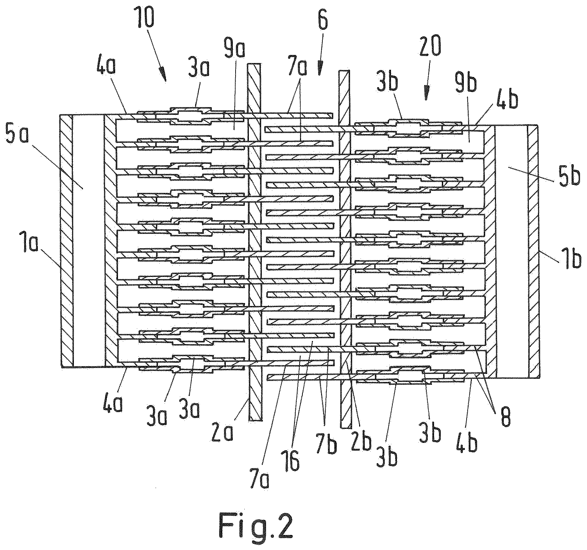

Die in Fig. 1 und Fig. 2 dargestellte Anordnung weist zwei Kühlkörper 1a, 1b auf, die jeweils eine Mehrzahl von Kanälen 5a, 5b für einen Kühlflüssigkeitsstrom aufweisen. Die Kanäle 5 verlaufen in der Darstellung von Fig. 1 mit ihrer Strömungsrichtung senkrecht zur Figurenebene, wogegen sie in Fig. 2 mit ihrer Strömungsrichtung in der Figurenebene von oben nach unten oder umgekehrt verlaufen. Äußere, nicht den Kanälen 5 zugewandte Oberflächen der Kühlkörper 5a, 5b sind einander zugewandt. Zwischen den Kühlkörpern 5a, 5b befinden sich Räume, in denen streifenförmige thermoelektrische Elemente 3a, 3b angeordnet sind und - in der Mitte zwischen den Kühlkörpern 5a, 5b ein Abgaskanal 6. Die Strömungsrichtung für das durch den Abgaskanal 6 strömende Abgas eines Verbrennungsmotors verläuft in Fig. 1 von unten nach oben in der Figurenebene und in Fig. 2 senkrecht zur Figurenebene auf den Betrachter zu.

In dem in Fig. 1 und Fig. 2 dargestellten Ausführungsbeispiel sind Rippen 4a, 4b als integraler Bestandteil der Kühlkörper 1a, 1b ausgeformt. Ein Fügen von Rippen und Kühlkörper entfällt daher. Von jedem der Kühlkörper 1a, 1b erstrecken sich in dem Ausführungsbeispiel zehn Rippen 4a, 4b in die Richtung des Abgaskanals 6. Die Rippen 4a, 4b dienen als Verbindung zu den streifenförmigen thermoelektrischen Elementen 3a, 3b. Mit jeder der Rippen 4a, 4b sind zwei thermoelektrische Elemente 3a, 3b verbunden, z.B. verklebt oder verlötet, sodass während des Betriebes der Anordnung überschüssige Wärme von den thermoelektrischen Elementen 3a, 3b über die Rippen 4a, 4b auf die innere Wand des Kühlkörpers 1a, 1b und von dort auf die Kühlflüssigkeit innerhalb des Kanals 5a, 5b übertragen wird. Die Kühlflüssigkeit transportiert die überschüssige Wärme ab. Auf diese Weise wird die mit den Rippen 4a, 4b verbundene Niedertemperaturseite der thermoelektrischen Elemente 3a, 3b auf einer niedrigen Temperatur gehalten.

Die streifenförmigen thermoelektrischen Elemente weisen in dem in Fig. 2 dargestellten Querschnitt eine sehr viel kleinere Querschnittsfläche auf im Vergleich zu der sehr viel größeren Oberfläche, die in Fig. 1 dargestellt ist. Insbesondere können von oben nach unten in der in Fig. 1 dargestellten Oberfläche der thermoelektrischen Elemente 3a, 3b die Materialpaare vieler thermoelektrischer Elemente übereinander angeordnet sein, wie dies an sich bereits aus dem Stand der Technik bekannt ist. Die thermoelektrischen Elemente selbst sind in Fig. 1 nicht dargestellt.

An den zu dem Abgaskanal 6 weisenden Hochtemperaturseiten sind die thermoelektrischen Elemente 3a, 3b jeweils paarweise mit einem rippenförmigen Wärmeleitkörper 7a, 7b verbunden, z.B. wiederum durch Verkleben oder Verlöten. Die innenliegenden, zu dem Abgaskanal 6 weisenden Endbereiche der thermoelektrischen Elemente 3a, 3b schließen jeweils paarweise einen Endbereich des Wärmeleitkörpers 7a, 7b zwischen sich ein. Der Wärmeleitkörper stabilisiert daher in gleicher Weise wie die Rippen 4a, 4b die Paare von thermoelektrischen Elementen 3a, 3b mechanisch.

Die Kühlkörper 1a, 1b tragen über die an ihnen im gezeigten Ausführungsbeispiel integral ausgeformten Rippen 4a, 4b die thermoelektrischen Elemente 3a, 3b, welche wiederum die Wärmeübertrager 7a, 7b tragen. Das gesamte Gewicht der thermoelektrischen Elemente 3a, 3b und der Wärmeübertrager 7a, 7b wird daher von den Kühlkörpern 1a, 1b getragen.

Nahe der hochtemperaturseitigen Enden der thermoelektrischen Elemente 3a, 3b verläuft eine Abdichtung 2a, 2b aus flexiblem Material, im Ausführungsbeispiel ein Vlies aus Mineralfasern. Die Wärmeübertrager 7a, 7b durchdringen die Abdichtung 2a, 2b, welche durch Klemmkräfte und optional durch zusätzlichen Klebstoff an den Wärmeleitkörpern 7a, 7b gehalten wird. Die von dem ersten Kühlkörper 1a getragenen Wärmeleitkörper 7a halten somit die Abdichtung 2a und die von dem zweiten Kühlkörper 1b getragenen zweiten Wärmeleitkörper 7b halten die zweite Abdichtung 2b. Die Abdichtungen 2a, 2b sind mattenförmig, d.h. sie weisen zwei großflächige Oberflächen auf, die an einander gegenüberliegenden Seiten der Abdichtung 2a, 2b angeordnet sind. Jeweils die äußere dieser Oberflächen ist den thermoelektrischen Elementen 3a, 3b und somit auch dem Kühlkörper 1a, 1b zugewandt, während die andere der großflächigen Oberflächen die Wand des Abgaskanals 6 bildet.

Innerhalb des Abgaskanals 6 sind die Wärmeleitkörper 7a, 7b, wie bereits beschrieben wurde, kammartig ineinander verschränkt, d.h. in dem Querschnitt der Fig. 2 folgt in der Reihenfolge in der Figurenebene von oben nach unten auf einen ersten Wärmeleitkörper 7a, der sich von links in der Figurenebene in den Abgaskanal 6 hineinerstreckt, ein Wärmeleitkörper 7b, der sich von rechts in den Abgaskanal hineinerstreckt, usw. Entsprechend der Anzahl von zehn Rippen 4a, 4b in dem Ausführungsbeispiel und zwanzig streifenförmigen thermoelektrischen Elementen 3a, 3b sind zehn erste Wärmeleitkörper 7a und zehn zweite Wärmeleitkörper 7b vorhanden. Jeweils in erster Wärmeleitkörper 7a und ein zweiter Wärmeleitkörper 7b bilden im Vergleich zu dem Gesamtströmungsquerschnitt des Abgaskanals 6 schmale Strömungskanäle 16. Insgesamt sind neunzehn solcher schmalen Strömungskanäle 16 in dem Ausführungsbeispiel gebildet. In Fig. 2 oben und unten kann jeweils ein weiterer schmaler oder etwas breiterer Strömungskanal gebildet sein, wenn sich dort eine (in Fig. 2 nicht dargestellte) Blende befindet, deren innenseitige, großflächige Oberfläche den streifenförmigen thermoelektrischen Elementen 3a, 3b und innerhalb des Abgaskanals 6 den Wärmeleitkörpern 7a, 7b zugewandt ist. Die Abdichtungen 2a, 2b können an der jeweiligen Blende abgestützt sein, sodass sie gemeinsam mit den oben und unten in der Figurenebene von Fig. 2 anzuordnenden Blenden die umlaufenden Wände des Abgaskanals 6 bilden. Die Blenden können daher auch als Wände bezeichnet werden.

Wie gut aus Fig. 2 erkennbar ist, trennen die Abdichtungen 2a, 2b den Abgaskanal 6 von jeweils einem Raum ab, in dem sich die ersten thermoelektrischen Elemente 3a (Raum 10) bzw. die zweiten thermoelektrischen Elemente 3b (Raum 20) befinden. Aufgrund der streifenförmigen Anordnung der thermoelektrischen Elemente 3 sind die Räume 10, 20 in schmale Teilräume 9a, 9b unterteilt. Z.B. die rechts unten in Fig. 2 dargestellten untersten zweiten thermoelektrischen Elemente 3b, die mit dem Bezugszeichen 8 bezeichnet sind, begrenzen einen dieser Teilräume 9b. Optional können die Teilräume 9a, 9b vor, während und/oder nach dem Betrieb der Anordnung von einem Spülgas durchströmt werden, wobei die Strömungsrichtung parallel zur Strömungsrichtung des heißen Gases in dem Abgaskanal 6 liegt und in Fig. 2 daher z.B. senkrecht zur Figurenebene verläuft.

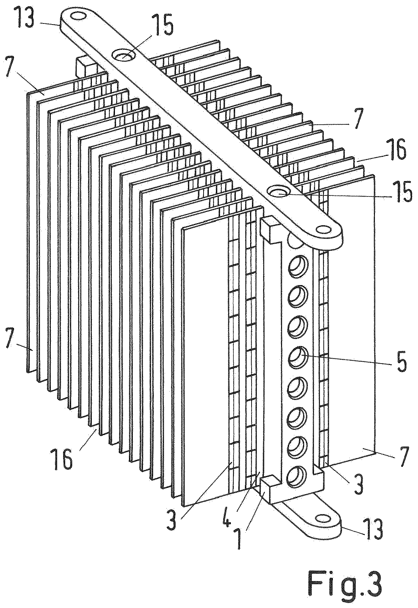

Fig. 3 zeigt eine Grundeinheit mit einem Kühlkörper 1, der z.B. der Kühlkörper 1a, 1b aus Fig. 1 und Fig. 2 sein kann, wenn sich in der Anordnung von Fig. 1 und Fig. 2 thermoelektrische Elemente, Rippen und Wärmeleitkörper beidseits des Kühlkörpers 1a, 1b befinden. In diesem Fall wären die Darstellungen in Fig. 1 und Fig. 2 lediglich Teildarstellungen und würden die außenseitig der Kühlkörper 1a, 1b angeordneten Rippen, thermoelektrischen Elemente und Wärmeleitkörper nicht zeigen.

Ausgehend von dem Kühlkörper 1 in Fig. 3 erstrecken sich beidseits nach rechts und nach links in der Darstellung der Fig. 3 Rippen 4, an denen streifenförmige thermoelektrische Elemente 3 befestigt sind. Wärmeleitkörper 7 sind mit den thermoelektrischen Elementen 3 verbunden, sodass sich jeweils von dem Kühlkörper 1 ausgehend die Folge von Rippe 4, thermoelektrischem Element 3 und Wärmeleitkörper 7 von dem Kühlkörper 1 wegerstreckt. In dem in Fig. 3 dargestellten Ausführungsbeispiel erstrecken sich auf jeder Seite des Kühlkörpers 1 sechszehn solche Anordnungen, die insgesamt lamellenförmige Stapel bilden, wobei zwischen den Wärmeleitkörpern 7 der Lamellen die schmalen Strömungskanäle 16 ausgebildet sind. Jede einzelne der Lamellen mit einer Rippe 4, einem streifenförmigen thermoelektrischen Element 3 und einem rippenförmigen Wärmeleitkörper 7 kann insbesondere so ausgestaltet sein, wie anhand von Fig. 1 und Fig. 2 beschrieben wurde.

In Fig. 3 nicht dargestellt sind die Abdichtungen, von denen jeweils eine links und rechts von dem in Fig. 3 dargestellten Kühlkörper 1 anzuordnen ist. Ferner nicht dargestellt sind entweder jeweils eine weitere Grundeinheit oder eine Gehäusewand, die jeweils links und rechts des in Fig. 3 dargestellten Kühlkörpers 1 anzuordnen ist.

Der Kühlkörper 1 in Fig. 3 weist acht von vorne rechts nach hinten links verlaufende Flüssigkeitskanäle 5 auf, wobei die Enden der meisten dieser Kanäle 5 vorzugsweise verschlossen sind, mit Ausnahme von zumindest einem Ende, das als Einflussöffnung oder Ausflussöffnung genutzt wird, um Kühlflüssigkeit in den Kühlkörper 1 einzuleiten oder aus diesem auszuleiten. Ferner weist der Kühlkörper 1 zwei senkrecht zu den Kanälen 5 verlaufende Kanäle 15 auf, einer im Bildvordergrund und einer im Bildhintergrund. Diese senkrecht verlaufenden Kanäle 15 verbinden sämtliche Kanäle 5 miteinander, sodass ein Verteiler an der Einflussseite und ein Sammler an der Ausflussseite gebildet ist. Die Enden der senkrecht verlaufenden Kühlkanäle 15 sind vorzugsweise verschlossen.

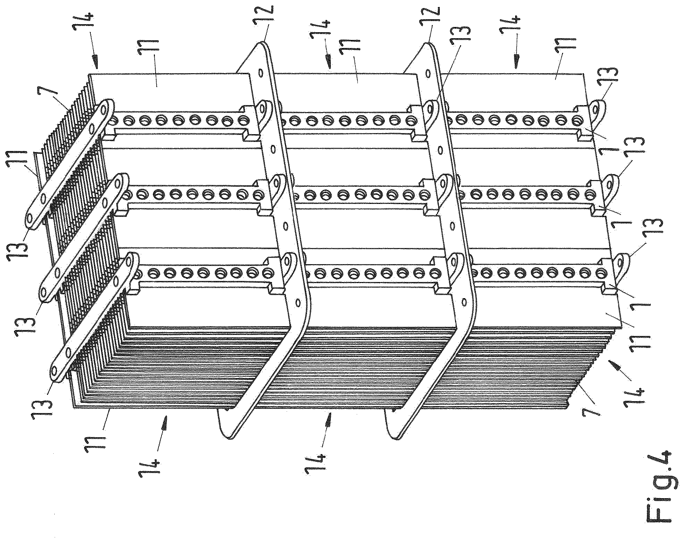

Fig. 4 zeigt eine Anordnung mit neun der in Fig. 3 dargestellten Grundeinheiten, wobei jeweils drei nebeneinander angeordnete Grundeinheiten 14 in drei Etagen übereinander angeordnet sind. In jeder Etage sind die Wärmeleitkörper 7 der in der Mitte der Etage angeordneten Grundeinheit mit den nach innen weisenden Wärmeleitkörpern der in der Etage außen angeordneten Grundeinheit kammartig verschränkt. Wie auch bereits in Fig. 3 unten und oben im Bild erkennbar ist, weisen die Kühlkörper 1 vorne und hinten sowie unten und oben jeweils einen Befestigungsvorsprung auf. Am Übergang der Etagen befindet sich jeweils eine Stützstruktur 12, die auf dem Niveau des Etagenübergangs den Stapel umläuft und an der die Kühlkörper 1 über ihre Befestigungsvorsprünge 13 befestigt sind. Dabei ist vorzugsweise lediglich entweder der untere Befestigungsvorsprung 13 oder der obere Befestigungsvorsprung 13 des Kühlkörpers 1 fest mit der Stützstruktur 12 verbunden. Der andere Befestigungsvorsprung wird vorzugsweise lediglich beweglich an der Stützstruktur 12 geführt. Auf diese Weise können sich die Grundeinheiten bei thermischer Ausdehnung und Kontraktion relativ zu den anderen Grundeinheiten bewegen. Es ist jedoch alternativ möglich, dass sämtliche Befestigungsvorsprünge 13 fest mit den Stützstrukturen 12 an den Etagenübergängen verbunden sind und die Stützstrukturen 12 relativ zu einem nicht in Fig. 4 dargestellten Gehäuse beweglich sind.

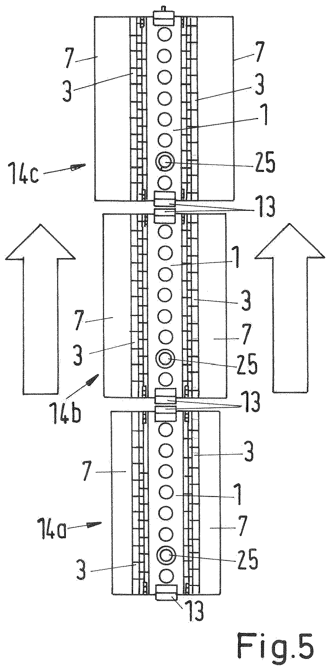

In jedem Fall wird bevorzugt, dass die unteren Befestigungsvorsprünge 13 der untersten Etage von Grundeinheiten 14 fest mit einem in Fig. 4 nicht dargestellten Gehäuse verbunden sind, nicht aber die oberen Befestigungsvorsprünge 13 der oberen Etage. Alternativ könnten die oberen Befestigungsvorsprünge 13 der oberen Etage mit dem Gehäuse fest verbunden sein, während die unteren Befestigungsvorsprünge 13 der unteren Etage nicht fest mit dem Gebäude verbunden sind. Die nicht fest mit dem Gehäuse verbundenen Befestigungsvorsprünge 13 sind vorzugsweise relativ zu dem Gehäuse beweglich geführt, um eine thermisch bedingte Ausdehnung und Kontraktion zu ermöglichen. In Fig. 5 ist ein Stapel von drei in Strömungsrichtung (durch von unten nach oben weisende Pfeile dargestellt) hintereinander angeordnet. Jede der Grundeinheiten weist einen Kühlkörper 1 und sich an gegenüberliegenden Seiten mit dem Kühlkörper 1 verbundene thermoelektrische Elemente 3 und daran befestigte Wärmeleitkörper 7 auf. Die Länge der Wärmeleitkörper 7 in der Richtung von dem Kühlkörper 1 weg in das Innere des Gaskanals (die Begrenzungen des Gaskanals durch die Abdichtungen sind in Fig. 5 nicht dargestellt) variiert jedoch bei den Grundeinheiten. Die in Strömungsrichtung vorne liegende Grundeinheit 14a hat die Wärmeleitkörper 7 mit der kleinsten Länge. Die mittlere Grundeinheit 14b hat die Wärmeleitkörper 7 mit etwas größerer Länge und die in Strömungsrichtung am Ende der Anordnung liegende Grundeinheit 14c hat die Wärmeleitkörper 7 mit der größten Länge, die noch etwas größer ist als die Länge der Wärmeleitkörper 7 der mittleren Grundeinheit 14b. Aufgrund der unterschiedlichen Länge und damit der unterschiedlich großen Oberflächen der Wärmeleitkörper 7 wird die Abnahme der Temperatur des heißen Gasstroms kompensiert.

Fig. 5 zeigt auch für jede der Grundeinheiten 14 einen Anschluss 25 zum Einleiten oder Ausleiten der Kühlflüssigkeit in den Kühlkörper 1, d.h. das entsprechende Ende des Kühlkanals ist an dem Anschluss 25 offen.

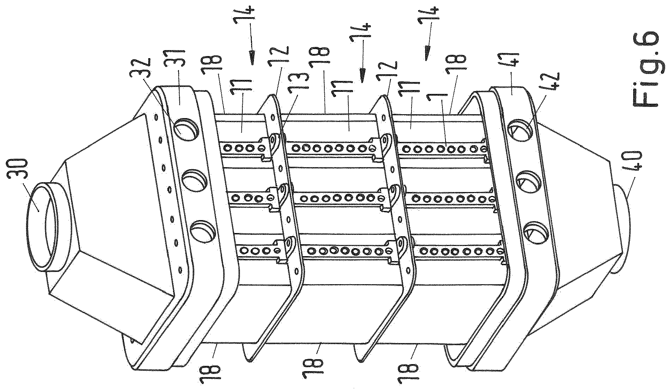

Fig. 6 zeigt einen thermoelektrischen Generator mit einem Stapel von Grundeinheiten wie in Fig. 4, wobei jedoch zusätzliche Gehäuseteile und Anschlüsse dargestellt sind. Außer den bereits in Fig. 4 dargestellten Blenden 11, die die Lamellenstapel vorne und hinten abschließen und die Wände der Gaskanäle vorne und hinten bilden, sind auch seitliche Wände 18 der rechts und links in der Darstellung liegenden Gaskanäle dargestellt. Ferner sind unten ein Abgaseinlass 10 mit trichterförmiger Erweiterung bis zu einem unteren Tragrahmen 41 und ein Abgasauslass 30 mit einer trichterförmigen Verjüngung ausgehend von einem oberen Tragrahmen 31 dargestellt. Der untere Tragrahmen 41 weist drei Öffnungen zum Einlassen von Spülgas in die von den Abdichtungen abgetrennten Räume auf. Der obere Tragrahmen 31 weist drei Auslassöffnungen 32 zum Abführen des Spülgases auf. Nicht in Fig. 6 dargestellt sind äußere Gehäusewände, die unten mit dem unteren Tragrahmen 41 und oben mit dem oberen Tragrahmen 31 verbunden oder durch den jeweiligen Rahmen geführt werden können.

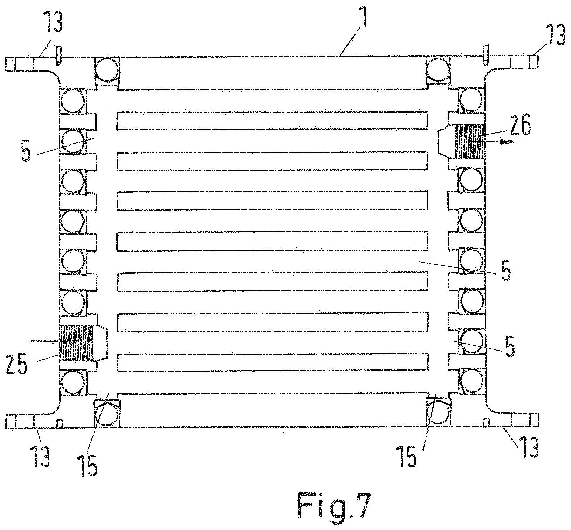

Vorzugsweise ist lediglich der untere Tragrahmen 41 fest mit dem Stapel der Grundeinheiten 14 verbunden, während der obere Tragrahmen 31 lediglich die Bewegungsfreiheit der oberen Etage von Grundeinheiten 14 einschränkt und eine Bewegung aufgrund thermischer Ausdehnung und Kontraktion ermöglicht. Der in Fig. 7 dargestellte Querschnitt durch einen Kühlkörper 1, z.B. den Kühlkörper einer der Grundeinheiten aus Fig. 3 bis Fig. 6, zeigt die in dem Ausführungsbeispiel 8 parallel zueinander verlaufenden Flüssigkeitskanäle 5 und die beiden senkrecht dazu verlaufenden Flüssigkeitskanäle 15. Nicht dargestellt sind die Verbindungen zu den ebenfalls nicht dargestellten thermoelektrischen Elementen, die in der Darstellung von Fig. 7 im Vordergrund und im Hintergrund an dem Kühlkörper 1 angeordnet sein können oder sind.

Der zweitunterste der acht parallel verlaufenden Kühlflüssigkeitskanäle 5 weist links in Fig. 7 eine Öffnung auf, die den Einlass 25 für die Kühlflüssigkeit bildet. Der zweitoberste der acht parallel verlaufenden Kühlflüssigkeitskanäle 5 weist rechts oben in Fig. 7 dargestellt eine Öffnung auf, die den Kühlflüssigkeitsauslass 26 bildet. Alle anderen Enden der Kanäle 5, 15 sind verschlossen, z.B. durch Stopfen. Die Verwendung von Stopfen ermöglicht es, die Kühlflüssigkeitskanäle 5, 15 durch Bohren in einem massiven Block zu erzeugen. Rechts und links, jeweils oben und unten sind die Befestigungsvorsprünge 13 dargestellt.

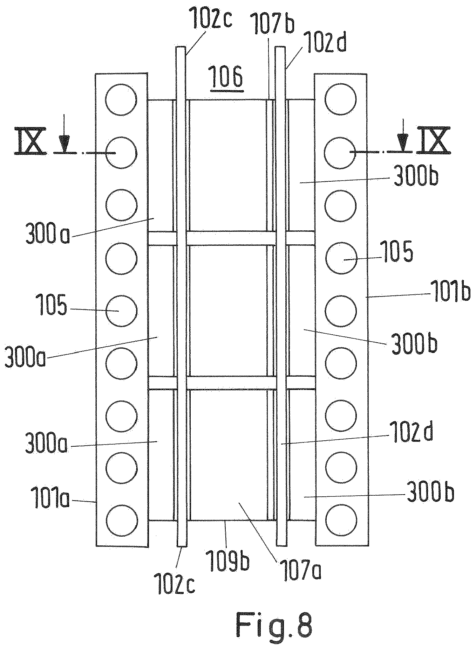

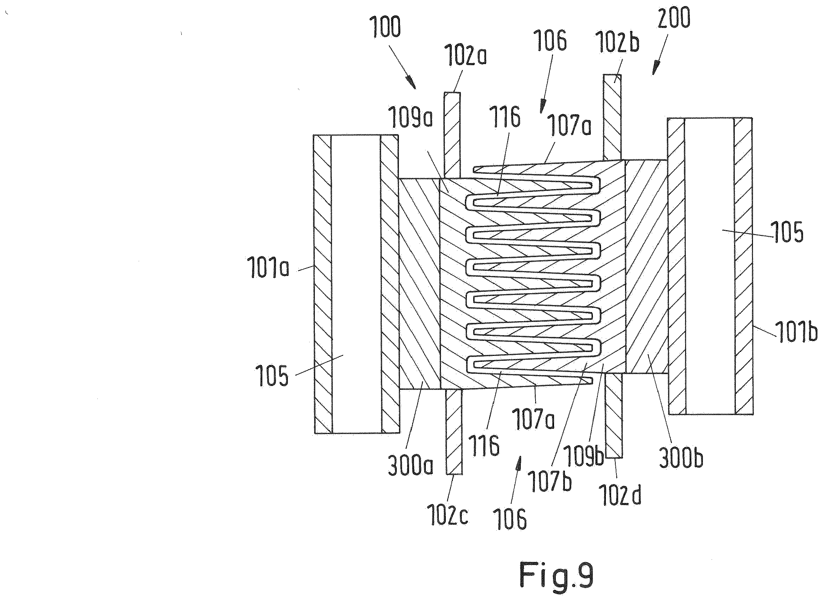

Die in Fig. 8 und Fig. 9 dargestellte Anordnung weist als Variante zu der in Fig. 1 und Fig. 2 dargestellten Anordnung blockförmige thermoelektrische Module 300a, 300b auf. Ähnlich wie in Fig. 1 und Fig. 2 ist jeweils rechts und links in der Anordnung ein Kühlkörper 101a, 101b mit mehreren parallel zueinander verlaufenden Kühlflüssigkeitskanälen 105 dargestellt. An der nach innen weisenden ebenen Oberfläche der Kühlkörper 101 ist eine Mehrzahl der blockförmigen thermoelektrischen Module 300a, 300b mit dem Kühlkörper 101 vollflächig verbunden, optional über jeweils ein nicht dargestelltes Ausgleichselement. An der Innenseite der thermoelektrischen Module 300a, 300b ist jeweils ein Wärmeleitkörper 109a, 109b angeordnet, die in dem Ausführungsbeispiel jeweils sich in ihrem Verlauf zu ihrem zu ihren freien Enden im Querschnitt verjüngende Rippen 107a, 107b aufweisen. Die Vorsprünge 107 sind kammartig ineinander verschränkt. Dadurch bildet sich ein in dem in Fig. 9 dargestellten Querschnitt mäanderförmiger Zwischenraum 116, der Teil des Abgaskanals 106 ist.

Die Strömungsrichtung des Abgaskanals 106 verläuft in der Darstellung der Fig. 8 von unten nach oben und in der Darstellung der Fig. 9 senkrecht zur Figurenebene von hinten nach vorne. Mit dem Wärmeleitkörper 109a ist eine erste Abdichtung kombiniert, die zwei Teile 102a, 102c aufweist. Mit dem zweiten Wärmeleitkörper 109b ist eine zweite Abdichtung mit Teilen 102b, 102d kombiniert. In der Darstellung der Fig. 9 ist erkennbar, dass sich die Teile 102a, 102b auf einer Seite der Anordnung mit den miteinander verschränkten Wärmeleitkörpern 109 und die Teile 102c, 102d an der gegenüberliegenden Seite der Anordnung der Wärmeleitkörper 109 befinden. Dementsprechend sind in der Darstellung der Fig. 8 die Stirnseiten lediglich der Abdichtungsteile 102c, 102d erkennbar. Die erste Abdichtung mit den Teilen 102a, 102c trennt den Gaskanal 106 von einem Raum 100 ab, der sich zwischen der Abdichtung und dem Kühlkörper befindet und in dem sich die ersten thermoelektrischen Module 300a befinden. Entsprechend trennt die zweite Abdichtung mit den Teilen 102b, 102d den Gaskanal 106 von einem Raum 200 ab, in dem sich die zweiten thermoelektrischen Module 300b befinden. Auf diese Weise wird verhindert, dass in dem Gaskanal 106 strömendes heißes Gas unmittelbar in Kontakt mit den thermoelektrischen Modulen 300 kommt. Wie auch bei den streifenförmigen thermoelektrischen Modulen der Anordnung in Fig. 1 und Fig. 2 kann daher eine höhere Temperaturdifferenz über die thermoelektrischen Module erreicht werden. Dabei wird Wärme aus dem Gaskanal mit hoher Effizienz in die Hochtemperaturseite der thermoelektrischen Module eingeleitet.

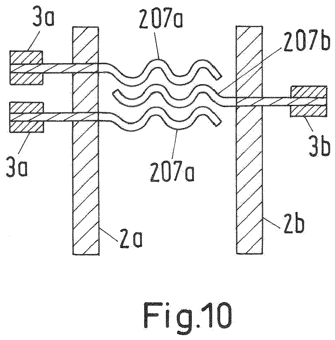

Fig. 10 zeigt ein Detail einer bevorzugten Variante der in Fig. 2 dargestellten Anordnung. Das Detail betrifft die Formgebung der Wärmeleitkörper in dem örtlichen Bereich, der durch den Abgaskanal gebildet wird und durch die Abdichtungen 2a, 2b an gegenüberliegenden Seiten begrenzt ist. Während die Wärmeleitkörper 7a, 7b in der in Fig. 2 dargestellten Ausführungsform plattenförmig mit geradem Verlauf entlang der Längsachse (von rechts nach links und von links nach rechts in Fig. 2 verlaufend) geformt sind, weisen die Wärmeleitkörper 207a, 207b in der in Fig. 10 dargestellten Ausführungsform einen in der Längsrichtung wellenförmigen Verlauf mit Wellenbergen und Wellentälern auf. Die Wellenberge und Wellentäler verlaufen senkrecht zur Figurenebene der Fig. 10. Es sind lediglich zwei erste Wärmeübertrager 207a und ein zweiter Wärmeübertrager 207b dargestellt. Die Wellentäler und Wellenberge der nächstbenachbarten ersten und zweiten Wärmeleitkörper 207a, 207b verlaufen parallel zueinander, sodass der Abstand der Oberflächen der nächstbenachbarten Wärmeleitkörper 207 im Verlauf der Wärmeleitkörper 207 von den thermoelektrischen Elementen 3a, 3b zu den freien Enden der Wärmeleitkörper 207 konstant oder ungefähr konstant ist. Unter ungefähr konstant wird verstanden, dass keine Abstandsänderung in dem genannten Verlauf auftritt, die auf einen Versatz in Längsrichtung oder eine unterschiedliche Form der Wellentäler und Wellenberge zurückzuführen ist. In der Praxis kann es jedoch insbesondere einen sich ändernden Abstand geben, weil die wellenförmigen Endabschnitte der Wärmeleitkörper 207 unbeabsichtigt verbogen sind.

Da es sich bei der Fig. 10 um eine Detaildarstellung handelt, sind lediglich die drei genannten Wärmeleitkörper 207, jeweils ein Teilabschnitt der Abdichtungen 200a, 200b und lediglich die hochtemperaturseitigen Endbereiche der thermoelektrischen Elemente 3a, 3b dargestellt, an denen die drei dargestellten Wärmeleitkörper 207 befestigt sind. In der in Fig. 2 dargestellten Art sind in der Praxis weitere thermoelektrische Elemente und Wärmeleitkörper vorhanden, wobei die Wärmleitkörper jedoch ebenfalls wellenförmige Endabschnitte haben.

Die wellenförmige, ineinander verschränkte Anordnung der Endabschnitte der Wärmeleitkörper führt zu einer im Vergleich zu der Formgebung in Fig. 2 vergrößerten Oberfläche der Wärmeleitkörper und damit zu einem verbesserten Wärmeübergang von dem heißen Gas auf die Wärmeleitkörper. Vorzugsweise wird die Strömung des heißen Gases in dem Abgaskanal jedoch nicht aufgrund der Wellenform der Wärmeleitkörper turbulent.

Vergrößert wird die Oberfläche der Endabschnitte der Wärmeleitkörper bezogen auf den Längsabschnitt, d.h. der Quotient des Wärmeübergangskoeffizienten und der Länge des Endabschnitts in der Längsrichtung ist größer. Dies ermöglicht es, die Länge des Endabschnitts kleiner zu wählen und dennoch einen guten Wärmeübergang von dem heißen Gas auf die Wärmeleitkörper zu erzielen. Wenn die Strömung des heißen Gases durch den Gaskanal nicht turbulent wird, ist der Strömungswiderstand lediglich geringfügig höher als bei der geraden Ausführung der Endabschnitte der Wärmeleitkörper in Fig. 2.

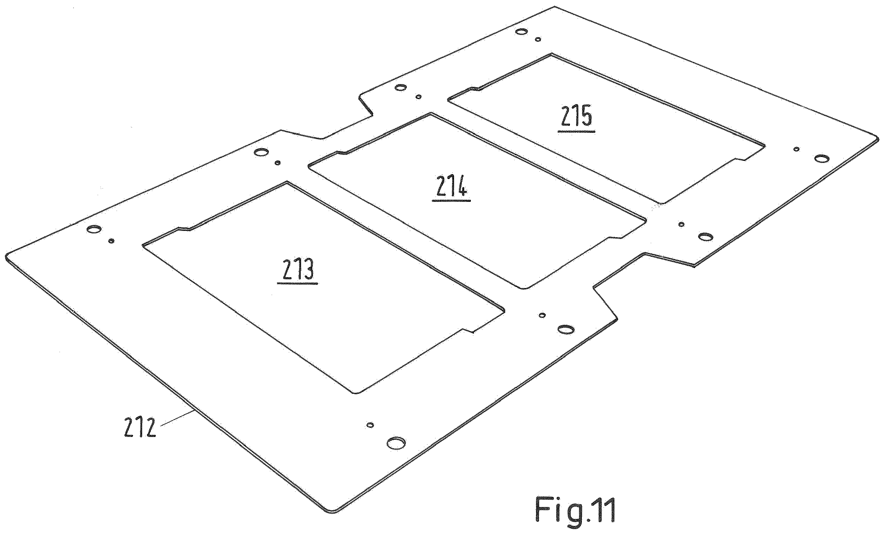

Fig. 11 zeigt eine Stützstruktur 212 ähnlich der in Fig. 4, die in Strömungsrichtung des heißen Gases zwischen zwei Etagen von hintereinander angeordneten Grundeinheiten angeordnet werden kann, um zumindest die Grundeinheiten einer der beiden Etagen an der Stützstruktur 212 abzustützen. Die Stützstruktur 212 ist insbesondere aus einem Metallblech gefertigt und weist drei (mit Ausnahme zusätzlicher Ausbuchtungen) ungefähr rechteckige Ausschnitte 213, 214, 215 für eine der Etagen, die Etagen oder für einen Übergang der Etagen auf. In der perspektivischen Darstellung der Fig. 11 verläuft die Strömungsrichtung für das heiße Gas von unten nach oben.

## Patentansprüche

1. Thermoelektrischer Generator zur Umwandlung von Wärme eines heißen Gasstroms in elektrische Energie, wobei der thermoelektrische Generator aufweist:
• zumindest ein thermoelektrisches Modul (3; 300) mit einer Mehrzahl von thermoelektrischen Elementen,
• einen Gaskanal (6; 106) an einer Hochtemperaturseite des thermoelektrischen Moduls (3; 300) zur Führung des heißen Gasstroms in einer Strömungsrichtung des Gaskanals (6; 106),
• einen Kühlkörper (1; 101) zur Kühlung des thermoelektrischen Moduls (3; 300) und
• zumindest einen Wärmeleitkörper (7; 109), der sich an der Hochtemperaturseite des thermoelektrischen Moduls (3; 300) in einer quer zur Strömungsrichtung verlaufenden Richtung in den Gaskanal (6; 106) hinein erstreckt und innerhalb des Gaskanals (6; 106) ein freies Ende aufweist, wobei der Wärmeleitkörper Teil des thermoelektrischen Moduls (3; 300) ist oder an der Hochtemperaturseite des thermoelektrischen Moduls (3; 300) mit dem thermoelektrischen Modul (3; 300) verbunden ist,
wobei der thermoelektrische Generator eine Abdichtung (2; 102) aufweist, **dadurch gekennzeichnet, dass**
- der Kühlkörper (1; 101) an einer Niedertemperaturseite des thermoelektrischen Moduls (3; 300) mit diesem in Kontakt ist,
- die Abdichtung einen Raum, der zwischen dem Kühlkörper (1; 101) und dem Gaskanal (6; 106) angeordnet ist, von dem Gaskanal (6; 106) trennt und in einem Betrieb des thermoelektrischen Generators gegen den in dem Gaskanal (6; 106) strömenden heißen Gasstrom abdichtet und
- sich die Abdichtung (2; 102) von dem Wärmeleitkörper (7; 109) oder von einem der Wärmeleitkörper (7; 109) zu einer Gaskanalwand oder zu einem tragenden Teil des thermoelektrischen Generators erstreckt, aber nicht mit der Gaskanalwand oder dem tragenden Teil des thermoelektrischen Generators verbunden ist.

2. Thermoelektrischer Generator nach Anspruch 1, wobei die Abdichtung (2; 102) aus einem flexiblen Material besteht.

3. Thermoelektrischer Generator nach Anspruch 2, wobei das flexible Material ausgestaltet ist, sich bei Einwirkung von äußeren Kräften zu verformen.

4. Thermoelektrischer Generator nach einem der Ansprüche 1 bis 3, wobei das Material der Abdichtung (2; 102) ein Vlies oder Gewebe aus Fasern aufweist.

5. Thermoelektrischer Generator nach einem der Ansprüche 1-4, wobei die Abdichtung (2; 102) zumindest an einer Stelle von dem Wärmeleitkörper (7; 109) oder einem der Wärmeleitkörper (7; 109) oder von dem thermoelektrischen Modul durchdrungen ist und/oder Teile der Abdichtung (2; 102) zumindest an einer Stelle durch den Wärmeleitkörper (7; 109) oder einen der Wärmeleitkörper (7; 109) oder durch das thermoelektrische Modul voneinander getrennt sind.

6. Thermoelektrischer Generator nach einem der Ansprüche 1-5, wobei Vorsprünge, die durch den Wärmeleitkörper (7; 109) oder durch eine Mehrzahl der Wärmeleitkörper (7; 109) gebildet sind und sich in den Gaskanal (6; 106) hinein erstrecken, als Rippen eines Wärmeübertragers zum Übertragen der Wärme des heißen Gasstroms auf das thermoelektrische Modul (3; 300) ausgestaltet sind.

7. Thermoelektrischer Generator nach einem der Ansprüche 1-6, wobei die thermoelektrischen Elemente jeweils ein Paar verschiedener Materialien aufweisen, die in einem ersten Kontaktbereich an der Niedertemperaturseite miteinander in Kontakt sind und in einem zweiten Kontaktbereich an der Hochtemperaturseite miteinander in Kontakt sind, so dass aufgrund einer höheren Temperatur in dem zweiten Kontaktbereich als in dem ersten Kontaktbereich eine elektrische Spannung zwischen dem ersten und dem zweiten Kontaktbereich erzeugt wird, und wobei sich der erste Kontaktbereich in dem Raum befindet, den die Abdichtung (2; 102) von dem Gaskanal (6; 106) trennt.

8. Thermoelektrischer Generator nach einem der Ansprüche 1-7, wobei der Raum, den die Abdichtung (2; 102) von dem Gaskanal (6; 106) trennt, separat von dem Gaskanal (6; 106) einen Einlass und einen Auslass aufweist, durch die vor, während und/oder nach einem Betrieb des thermoelektrischen Generators ein Spülgas zum Spülen des Raums einlassbar und auslassbar ist.

9. Thermoelektrischer Generator nach einem der Ansprüche 1-8, wobei der Kühlkörper (1; 101) mit einem das Gewicht des thermoelektrischen Generators tragenden Teil verbunden ist und von dem tragenden Teil getragen wird und wobei der Kühlkörper (1; 101) das thermoelektrische Modul (3; 300) trägt.

10. Schienenfahrzeug mit einem thermoelektrischen Generator nach einem der Ansprüche 1-9, wobei das Schienenfahrzeug einen Motor aufweist und der thermoelektrische Generator in einem Abgasstrang des Motors angeordnet oder mit dem Abgasstrang thermisch gekoppelt ist.

11. Verfahren zum Herstellen eines thermoelektrischer Generators zur Umwandlung von Wärme eines heißen Gasstroms in elektrische Energie, mit folgenden Schritten:
• Bereitstellen zumindest eines thermoelektrischen Moduls (3; 300) mit einer Mehrzahl von thermoelektrischen Elementen,
• Bereitstellen eines Gaskanals (6; 106) zur Führung des heißen Gasstroms in einer Strömungsrichtung des Gaskanals (6; 106) an einer Hochtemperaturseite des thermoelektrischen Moduls (3; 300),
• Anordnen eines Kühlkörpers (1; 101) zur Kühlung des thermoelektrischen Moduls (3; 300) an einer Niedertemperaturseite des thermoelektrischen Moduls (3; 300),
• Ankoppeln des Kühlkörpers (1; 101) an das thermoelektrische Modul (3; 300) an der Niedertemperaturseite und
• Anordnen zumindest eines Wärmeleitkörpers (7; 109) an der Hochtemperaturseite des thermoelektrischen Moduls (3; 300), so dass sich der Wärmeleitkörper (7; 109) in einer Richtung quer zu der Strömungsrichtung in den Gaskanal (6; 106) hinein erstreckt und innerhalb des Gaskanals (6; 106) ein freies Ende aufweist, wobei der Wärmeleitkörper (7; 109) Teil des thermoelektrischen Moduls (3; 300) ist oder an der Hochtemperaturseite des thermoelektrischen Moduls (3; 300) mit dem thermoelektrischen Modul (3; 300) verbunden wird,
wobei eine Abdichtung (2; 102) so angeordnet wird, dass sie einen Raum, der zwischen dem Kühlkörper (1; 101) und dem Gaskanal (6; 106) angeordnet ist, von dem Gaskanal (6; 106) trennt und den Raum in einem Betrieb des thermoelektrischen Generators gegen den in dem Gaskanal (6; 106) strömenden heißen Gasstrom abdichtet und
wobei die Abdichtung (2; 102) derart angeordnet wird, dass sie sich von dem Wärmeleitkörper (7; 109) oder von einem der Wärmeleitkörper (7; 109) zu einer Gaskanalwand oder zu einem tragenden Teil des thermoelektrischen Generators erstreckt, aber nicht mit der Gaskanalwand oder dem tragenden Teil des thermoelektrischen Generators verbunden ist.

## Claims

1. A thermoelectric generator for converting heat of a hot gas flow into electrical energy, wherein the thermoelectric generator has the following:
• at least one thermoelectric module (3; 300) with a plurality of thermoelectric elements,
• a gas channel (6; 106) on a high-temperature side of the thermoelectric module (3; 300) for conducting the hot gas flow in a flow direction of the gas channel (6; 106),
• a heat sink (1; 101) for cooling the thermoelectric module (3; 300) and
• at least one heat-conducting member (7; 109), which on the hot-temperature side of the thermoelectric module (3; 300) extends into the gas channel (6; 106) in a direction running transverse to the flow direction and within the gas channel (6; 106) has a free end, wherein the heat-conducting member is part of the thermoelectric module (3; 300) or is connected on the hot-temperature side of the thermoelectric module (3; 300) to the thermoelectric module (3; 300),
wherein the thermoelectric generator has a seal (2; 102), **characterised in that**
- the heat sink (1; 101) is in contact with the thermoelectric module (3; 300) on a low-temperature side thereof,
- the seal separates a space, which is arranged between the heat sink (1; 101) and the gas channel (6; 106), from the gas channel (6; 106) and, during operation of the thermoelectric generator, seals the space with respect to the hot gas flow flowing in the gas channel (6; 106), and
- the seal (2; 102) extends from the heat-conducting member (7; 109) or from one of the heat-conducting members (7; 109) to a gas channel wall or to a supporting part of the thermoelectric generator, but is not connected to the gas channel wall or the supporting part of the thermoelectric generator.

2. The thermoelectric generator according to claim 1, wherein the seal (2; 102) consists of a flexible material.

3. The thermoelectric generator according to claim 2, wherein the flexible material is designed to deform under the influence of external forces.

4. The thermoelectric generator according to any one of claims 1-3, wherein the material of the seal (2; 102) comprises a nonwoven or woven fabric formed from fibres.

5. The thermoelectric generator according to any one of claims 1-4, wherein the seal (2; 102) is penetrated at least at one location by the heat-conducting member (7; 109) or one of the heat-conducting members (7; 109) or by the thermoelectric module, and/or parts of the seal (2; 102) are separated from one another at least at one location by the heat-conducting member (7; 109) or one of the heat-conducting members (7; 109) or by the thermoelectric module.

6. The thermoelectric generator according to any one of claims 1-5, wherein protrusions which are formed by the heat-conducting member (7; 109) or by a plurality of the heat-conducting members (7; 109) and extend into the gas channel (6; 106) are embodied as ribs of a heat exchanger for transferring the heat of the hot gas flow to the thermoelectric module (3;300).

7. The thermoelectric generator according to any one of claims 1-6, wherein the thermoelectric elements each comprise a pair of different materials, which are in contact with one another in a first contact region on the low-temperature side and are in contact with one another in a second contact region on the high-temperature side, such that an electrical voltage is generated between the first and the second contact region on account of a higher temperature in the second contact region than in the first contact region, and wherein the first contact region is located in the space that the seal (2; 102) separates from the gas channel (6; 106).

8. The thermoelectric generator according to any one of claims 1-7, wherein the space that the seal (2; 102) separates from the gas channel (6; 106) has an inlet and an outlet separately from the gas channel (6; 106), through which inlet and outlet a flushing gas for flushing the space can be admitted and discharged during and/or after operation of the thermoelectric generator.

9. The thermoelectric generator according to any one of claims 1-8, wherein the heat sink (1; 101) is connected to a part supporting the weight of the thermoelectric generator and is supported by the supporting part, and wherein the heat sink (1; 101) supports the thermoelectric module (3; 300).

10. A rail vehicle with a thermoelectric generator according to any one of claims 1-9, wherein the rail vehicle has an engine and the thermoelectric generator is arranged in an exhaust tract of the engine or is thermally coupled to the exhaust tract.

11. A method for producing a thermoelectric generator for converting heat of a hot gas flow into electrical energy, comprising the following steps:
• providing at least one thermoelectric module (3; 300) having a plurality of thermoelectric elements,
• providing a gas channel (6; 106) for guiding the hot gas flow in a flow direction of the gas channel (6; 106) on a hot-temperature side of the thermoelectric module (3; 300),
• arranging a heat sink (1; 101) for cooling the thermoelectric module (3; 300) on a low-temperature side of the thermoelectric module (3; 300),
• coupling the heat sink (1; 101) to the thermoelectric module (3; 300) on the low-temperature side, and
• arranging at least one heat-conducting member (7; 109) on the high-temperature side of the thermoelectric module (3; 300), such that the heat-conducting member (7; 109) extends into the gas channel (6; 106) in a direction transverse to the flow direction and within the gas channel (6; 106) has a free end, wherein the heat-conducting member (7; 109) is part of the thermoelectric module (3; 300) or is connected to the thermoelectric module (3; 300) on the high-temperature side of the thermoelectric module (3; 300),
wherein a seal (2; 102) is arranged such that it separates a space, which is arranged between the heat sink (1; 101) and the gas channel (6; 106), from the gas channel (6; 106) and, during operation of the thermoelectric generator, seals the space with respect to the hot gas flow flowing in the gas channel (6; 106),
wherein the seal (2; 102) is arranged in such a way that it extends from the heat-conducting member (7; 109) or from one of the heat-conducting members (7; 109) to a gas channel wall or to a supporting part of the thermoelectric generator, but is not connected to the gas channel wall or the supporting part of the thermoelectric generator.

## Revendications

1. Générateur thermoélectrique servant à convertir de la chaleur d'un flux de gaz très chaud en une énergie électrique, dans lequel le générateur thermoélectrique présente :
- au moins un module thermoélectrique (3 ; 300) avec une multitude d'éléments thermoélectriques,
- un canal de gaz (6 ; 106) au niveau d'un côté à température élevée du module thermoélectrique (3 ; 300) servant à guider le flux de gaz très chaud dans une direction d'écoulement du canal de gaz (6 ; 106),
- un corps de refroidissement (1 ; 101) servant à refroidir le module thermoélectrique (3 ; 300) et
- au moins un corps conducteur de chaleur (7 ; 109), qui s'étend, au niveau du côté à température élevée du module thermoélectrique (3 ; 300), dans une direction s'étendant de manière transversale par rapport à la direction d'écoulement, à l'intérieur du canal de gaz (6 ; 106) et présente, à l'intérieur du canal de gaz (6 ; 106), une extrémité libre, dans lequel le corps conducteur de chaleur fait partie du module thermoélectrique (3 ; 300) ou est relié au module thermoélectrique (3 ; 300) au niveau du côté à température élevée du module thermoélectrique (3 ; 300),
dans lequel le générateur thermoélectrique présente un système d'étanchéification (2 ; 102),
**caractérisé en ce que**
- le corps de refroidissement (1 ; 101) est en contact, au niveau d'un côté à basse température du module thermoélectrique (3 ; 300) avec celui-ci,
- le système d'étanchéification sépare un espace, qui est disposé entre le corps de refroidissement (1 ; 101) et le canal de gaz (6 ; 106), du canal de gaz (6 ; 106) et l'étanchéifie contre le flux de gaz très chaud s'écoulant dans le canal de gaz (6 ; 106) dans un fonctionnement du générateur thermoélectrique, et
- le système d'étanchéification (2 ; 102) s'étend depuis le corps conducteur de chaleur (7 ; 109) ou depuis un des corps conducteurs de chaleur (7 ; 109) vers une paroi de canal de gaz ou vers une partie porteuse du générateur thermoélectrique, mais n'est pas relié à la paroi de canal de gaz ou à la partie porteuse du générateur thermoélectrique.

2. Générateur thermoélectrique selon la revendication 1, dans lequel le système d'étanchéification (2 ; 102) est constitué d'un matériau flexible.

3. Générateur thermoélectrique selon la revendication 2, dans lequel le matériau flexible est configuré pour se déformer sous l'effet de forces extérieures.

4. Générateur thermoélectrique selon l'une quelconque des revendications 1 à 3, dans lequel le matériau du système d'étanchéification (2 ; 102) présente un non-tissé ou un tissu composé de fibres.

5. Générateur thermoélectrique selon l'une quelconque des revendications 1 - 4, dans lequel le système d'étanchéification (2 ; 102) est pénétré au moins au niveau d'un emplacement par le corps conducteur de chaleur (7 ; 109) ou un des corps conducteurs de chaleur (7 ; 109) ou par le module thermoélectrique, et/ou des parties du système d'étanchéification (2 ; 102) sont séparées au moins au niveau d'un emplacement les unes des autres par le corps conducteur de chaleur (7 ; 109) ou un des corps conducteurs de chaleur (7 ; 109) ou par le module thermoélectrique.

6. Générateur thermoélectrique selon l'une quelconque des revendications 1 - 5, dans lequel des parties faisant saillie, qui sont formées par le corps conducteur de chaleur (7 ; 109) ou par une multitude de corps conducteurs de chaleur (7 ; 109) et s'étendent à l'intérieur du canal de gaz (6 ; 106), sont configurées en tant que nervures d'un échangeur de chaleur servant à transférer la chaleur du flux de gaz très chaud sur le module thermoélectrique (3 ; 300).

7. Générateur thermoélectrique selon l'une quelconque des revendications 1 - 6, dans lequel les éléments thermoélectriques présentent respectivement une paire de matériaux différents, qui sont en contact l'un avec l'autre dans une première zone de contact au niveau du côté à faible température et sont en contact l'un avec l'autre dans une deuxième zone de contact au niveau du côté à température élevée de sorte qu'une tension électrique entre la première et la deuxième zone de contact est générée du fait d'une température plus élevée dans la deuxième zone de contact que dans la première zone de contact, et dans lequel la première zone de contact se trouve dans l'espace, que le système d'étanchéification (2 ; 102) sépare du canal de gaz (6 ; 106) .

8. Générateur thermoélectrique selon l'une quelconque des revendications 1 - 7, dans lequel l'espace, que le système d'étanchéification (2 ; 102) sépare du canal de gaz (6 ; 106), présente séparément du canal de gaz (6 ; 106), une entrée et une sortie, par lesquelles, avant, pendant et/ou après un fonctionnement du générateur thermoélectrique, un gaz de rinçage servant à rincer l'espace peut entrer et sortir.

9. Générateur thermoélectrique selon l'une quelconque des revendications 1 - 8, dans lequel le corps de refroidissement (1 ; 101) est relié à une partie supportant le poids du générateur thermoélectrique et est supporté par la partie porteuse, et dans lequel le corps de refroidissement (1 ; 101) supporte le module thermoélectrique (3 ; 300).

10. Véhicule sur rails avec un générateur thermoélectrique selon l'une quelconque des revendications 1 - 9, dans lequel le véhicule sur rails présente un moteur et le générateur thermoélectrique est disposé dans une ligne d'échappement du moteur ou est couplé thermiquement à la ligne d'échappement.

11. Procédé servant à fabriquer un générateur thermoélectrique servant à convertir de la chaleur d'un flux de gaz très chaud en une énergie électrique, avec des étapes suivantes :
- fourniture d'au moins un module thermoélectrique (3 ; 300) avec une multitude d'éléments thermoélectriques,
- fourniture d'un canal de gaz (6 ; 106) servant à guider le flux de gaz très chaud dans une direction d'écoulement du canal de gaz (6 ; 106) au niveau d'un côté à température élevée du module thermoélectrique (3 ; 300),
- agencement d'un corps de refroidissement (1 ; 101) servant à refroidir le module thermoélectrique (3 ; 300) au niveau d'un côté à basse température du module thermoélectrique (3 ; 300),
- accouplement du corps de refroidissement (1 ; 101) au module thermoélectrique (3 ; 300) au niveau du côté à basse température, et
- agencement d'au moins un corps conducteur de chaleur (7 ; 109) au niveau du côté à température élevée du module thermoélectrique (3 ; 300) de sorte que le corps conducteur de chaleur (7 ; 109) s'étend dans une direction de manière transversale par rapport à la direction d'écoulement à l'intérieur du canal de gaz (6 ; 106) et présente à l'intérieur du canal de gaz (6 ; 106) une extrémité libre, dans lequel le corps conducteur de chaleur (7 ; 109) fait partie du module thermoélectrique (3 ; 300) ou est relié au niveau du côté à température élevée du module thermoélectrique (3 ; 300) au module thermoélectrique (3 ; 300),
dans lequel un système d'étanchéification (2 ; 102) est disposé de telle sorte qu'il sépare un espace, qui est disposé entre le corps de refroidissement (1 ; 101) et le canal de gaz (6 ; 106), du canal de gaz (6 ; 106) et étanchéifie l'espace contre le flux de gaz très chaud s'écoulant dans le canal de gaz (6 ; 106) lors d'un fonctionnement du générateur thermoélectrique, et
dans lequel le système d'étanchéification (2 ; 102) est disposé de telle manière qu'il s'étend depuis le corps conducteur de chaleur (7 ; 109) ou depuis un des corps conducteurs de chaleur (7 ; 109) vers une paroi de canal de gaz ou vers une partie porteuse du générateur thermoélectrique, mais n'est pas relié à la paroi de canal de gaz ou à la partie porteuse du générateur thermoélectrique.
